# EUROPEAN PATENT APPLICATION

(11) **EP 4 734 489 A1**
(43) Date of publication of application: **29.04.2026**
(21) Application number: 25730557.3
(22) Date of filing: 11.06.2025
(51) Int. Cl.: H04M 1/02, H05K 1/02, H05K 9/00

(54) **FOLDABLE ELECTRONIC DEVICE COMPRISING IMPEDANCE CIRCUIT AND SWITCH CIRCUIT**

(30) Priority: 06.09.2024 KR 20240121936; 30.09.2024 KR 20240133402; 07.11.2024 KR 20240157435
(71) Applicant: SAMSUNG ELECTRONICS CO., LTD., Yeongtong-gu Suwon-si, Gyeonggi-do 16677 (KR)
(72) Inventor: JO, Kyunghwan, Suwon-si, Gyeonggi-do 16677 (KR); MEANG, Jiyeol, Suwon-si, Gyeonggi-do 16677 (KR); SONG, Chanmi, Suwon-si, Gyeonggi-do 16677 (KR); KO, Byungkuk, Suwon-si, Gyeonggi-do 16677 (KR); KIM, Byungjoon, Suwon-si, Gyeonggi-do 16677 (KR); KIM, Sungsoo, Suwon-si, Gyeonggi-do 16677 (KR); KIM, Eunji, Suwon-si, Gyeonggi-do 16677 (KR); LEE, Wonho, Suwon-si, Gyeonggi-do 16677 (KR)
(74) Representative: Appleyard Lees IP LLP
(86) International application number: PCT/KR2025/007973
(87) International publication number: WO 2026/054248

(57) **Abstract**

A foldable electronic device includes a foldable housing including a first housing part, a second housing part, and a third housing part, and a flexible display. The first housing part includes a bracket, a plate disposed between the bracket and a rear side of the first housing part, a printed circuit board (PCB) disposed on the bracket, impedance circuitry disposed on the PCB, and switch circuitry disposed on the PCB. The switch circuitry is configured to electrically connect the plate and the impedance circuitry based on a state of the foldable electronic device.

## Description

### [Technical Field]

The present disclosure relates to a foldable electronic device including impedance circuitry and switch circuitry.

### [Background Art]

A foldable electronic device may include housing parts that are rotatably coupled and a flexible display. According to a rotation of the housing parts, a portion of the flexible display may be bent. When the electronic device is fully folded, the housing parts of the electronic device may overlap each other. The foldable electronic device includes brackets configured to function as grounds of the foldable electronic device. For example, the first housing part can include a bracket corresponding to a ground of the foldable electronic device. The brackets include metal materials and each of the brackets are electrically conductive structure. Thus, when the brackets face each other, parasitic components (e.g., parasitic capacitance) may be formed between the brackets. The parasitic components can deteriorate the performance of electronic devices that include antennas.

The above-described information may be provided as related art for the purpose of helping the understanding of the present disclosure. No claim or determination is raised as to whether any of the above-described content may be applied as prior art related to the present disclosure.

### [Disclosure]

### [Technical Solution]

A foldable electronic device is described. The foldable electronic device may comprise a foldable housing including a first housing part, a second housing part configured to rotate with respect to the first housing part, and a third housing part configured to rotate with respect to the second housing part. A multi-folded state of the foldable electronic device may have a front side of the second housing part facing a front side of the first housing part and a front side of the third housing part facing a rear side of the first housing part. The foldable electronic device may comprise a flexible display including a first portion defining a portion of the front side of the first housing part, a second portion defining a portion of the front side of the second housing part, and a third portion defining a portion of the front side of the third housing part. The first housing part may include a bracket corresponding to a ground of the first housing part, a plate disposed between the bracket of the first housing part and the rear side of the first housing part, a printed circuit board (PCB) disposed on the bracket, impedance circuitry disposed on the PCB, and switch circuitry disposed on the PCB. The switch circuitry may be configured to electrically connect the impedance circuitry and the plate based on a state of the foldable electronic device.

A foldable electronic device is described. The foldable electronic device may comprise a foldable housing including a first housing part, a second housing part configured to rotate with respect to the first housing part, and a third housing part configured to rotate with respect to the second housing part. A multi-folded state of the foldable electronic device may have a rear side of the first housing part facing a rear side of the second housing part and a front side of the third housing part facing a front side of the second housing part. The foldable electronic device may comprise a flexible display including a first portion defining a portion of the front side of the first housing part, a second portion defining a portion of the front side of the second housing part, and a third portion defining a portion of the front side of the third housing part. The first housing part may include a bracket corresponding to a ground of the first housing part, a plate disposed between the bracket and the rear side of the first housing part, a printed circuit board (PCB) disposed on the bracket, a contact disposed on the PCB, configured to electrically connect the PCB and the plate, impedance circuitry disposed on the PCB, and switch circuitry disposed on the PCB. The switch circuitry may be configured to electrically disconnect the impedance circuitry from the plate electrically connected to the PCB via the contact when the foldable electronic device is in an unfolded state. The switch circuitry may be configured to electrically connect the impedance circuitry to the plate electrically connected to the PCB via the contact when the foldable electronic device is in the multi-folded state.

### [Description of the Drawings]

The subject-matter of the present disclosure is best understood with reference to the accompanying figures, in which:
FIG. 1 is a block diagram of an electronic device in a network environment according to various embodiments.
FIG. 2A illustrates an example of a first state of an electronic device;
FIG. 2B illustrates an example of a second state of an electronic device;
FIG. 2C illustrates an example of a third state of an electronic device;
FIG. 3A is a plan view of an electronic device with a flexible display removed;
FIG. 3B is a rear view of an electronic device with a rear cover and a display removed;
FIG. 4 illustrates a multi-folded state of a foldable electronic device;
FIG. 5 indicates efficiency of an antenna of a foldable electronic device according to a frequency, according to an embodiment;
FIG. 6 is a block diagram indicating components of a foldable electronic device according to an embodiment;
FIG. 7 illustrates the inside of a first housing part according to an embodiment.
FIG. 8 is an exploded perspective view of a first housing part of FIG. 7;
FIG. 9 is a flow chart indicating an operation of switch circuitry of a foldable electronic device according to an embodiment;
FIG. 10 illustrates an upper portion of a first housing part of a foldable electronic device according to an embodiment;
FIG. 11 is an exploded view of a fourth bracket of FIG. 10;
FIG. 12 is a plan view of a fourth bracket of FIG. 10;
FIG. 13 is a cross-sectional view of a foldable electronic device according to an embodiment, cut along line A-A' of FIG. 10;
FIGS. 14 and 15 illustrate a plate;
FIG. 16 illustrates a lower portion of a first housing part of a foldable electronic device according to an embodiment;
FIG. 17 is a graph indicating efficiency of an antenna of a foldable electronic device according to a frequency, according to an embodiment;
FIG. 18 illustrates a foldable electronic device according to an embodiment;
FIG. 19 is a cross-sectional view of a foldable electronic device according to an embodiment, cut along line B-B' of FIG. 18;
FIG. 20A illustrates an example of a first state of an electronic device;
FIG. 20B illustrates an example of a second state of an electronic device;
FIG. 20C illustrates an example of a third state of an electronic device; and
FIG. 21 illustrates the inside of a first housing part according to an embodiment.

### [Mode for Invention]

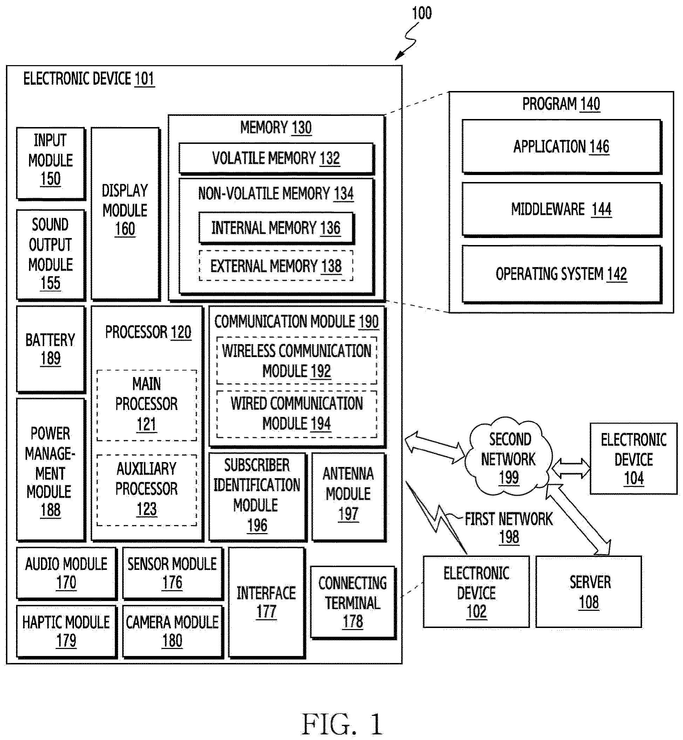

FIG. 1 is a block diagram of an electronic device in a network environment according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

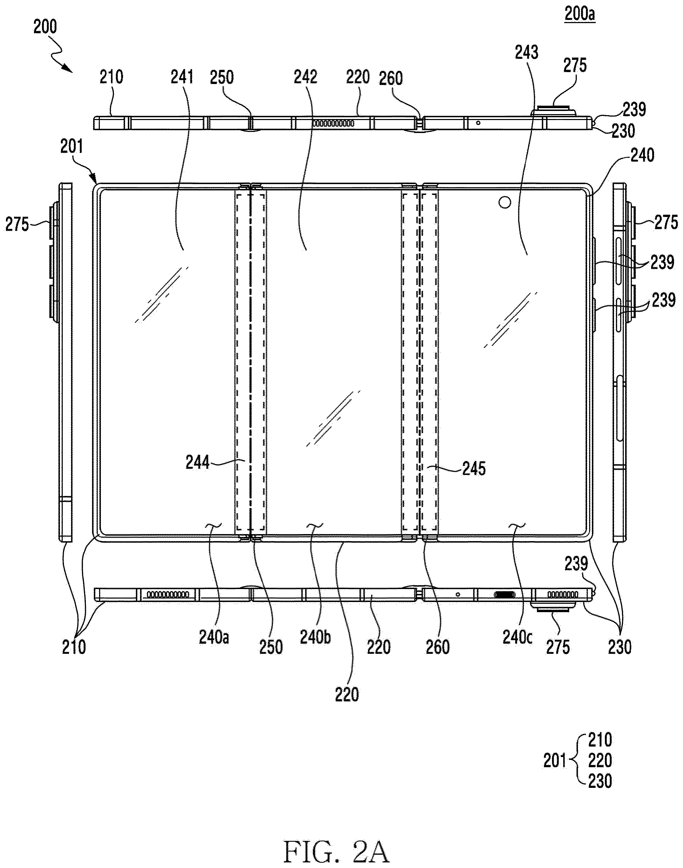

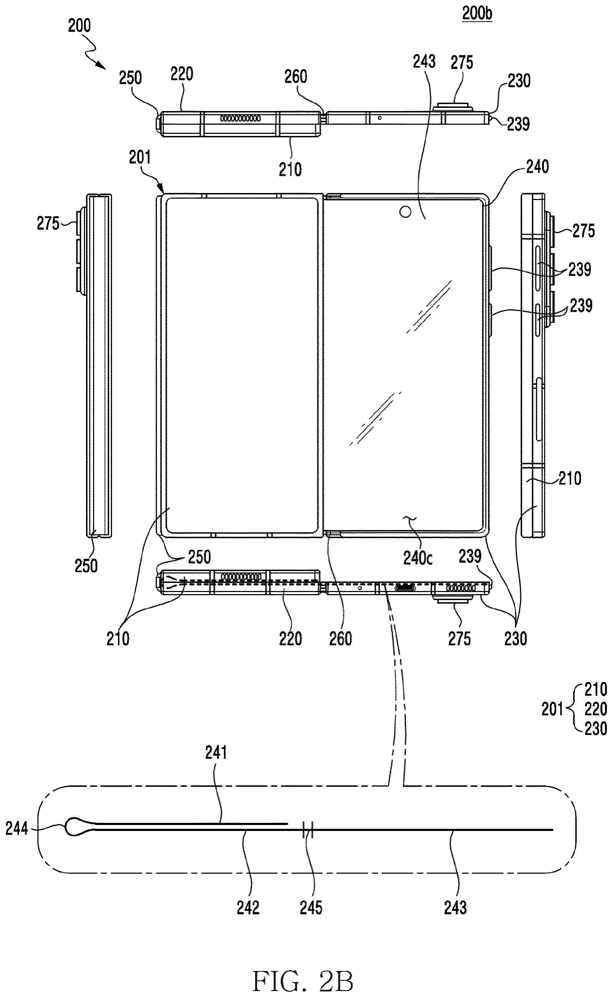

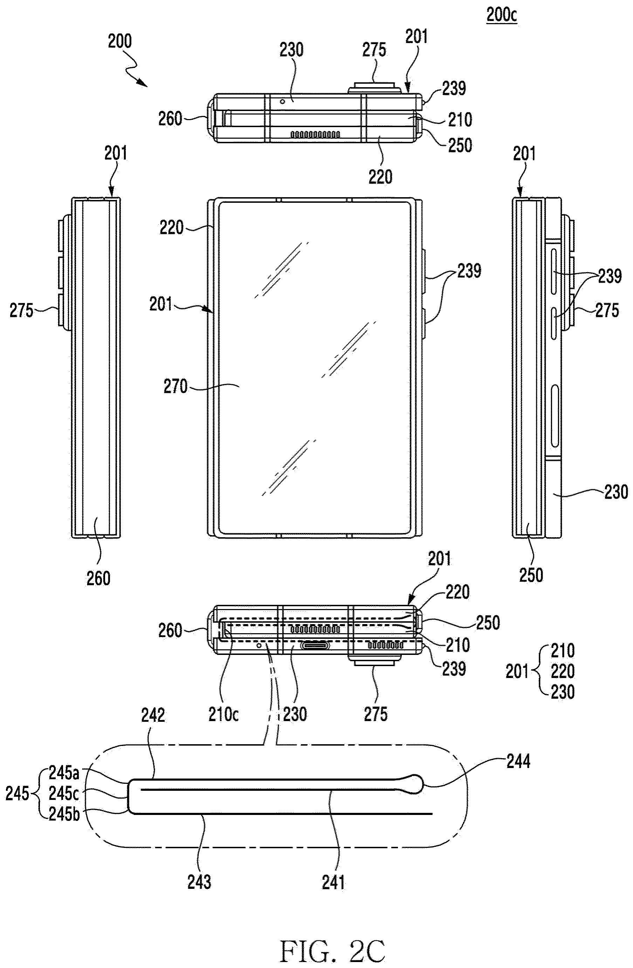

FIG. 2A illustrates an example of a first state of an electronic device. FIG. 2B illustrates an example of a second state of an electronic device. FIG. 2C illustrates an example of a third state of an electronic device.

Referring to FIGS. 2A, 2B, and 2C, a foldable electronic device 200 may include a foldable housing 201, a flexible display 240, a first hinge assembly 250, a second hinge assembly 260, and a display 270. The foldable housing 201 may include a first housing part 210, a second housing part 220, and a third housing part 230.

According to an embodiment, the first housing part 210 may be rotatably coupled to the second housing part 220 by the first hinge assembly 250. The second housing part 220 and the first housing part 210 may be rotated with respect to the first hinge assembly 250. While the first housing part 210 is rotated with respect to the first hinge assembly 250, the second housing part 220 may be rotated with respect to the first hinge assembly 250. For example, when the second housing part 220 and the first housing part 210 are rotated with respect to the first hinge assembly 250, an angular displacement of the second housing part 220 may be substantially the same as an angular displacement of the first housing part 210.

According to an embodiment, the third housing part 230 may be rotatably coupled to the second housing part 220 by the second hinge assembly 260. The second housing part 220 and the third housing part 230 may be rotated with respect to the second hinge assembly 260. While the second housing part 220 is rotated with respect to the second hinge assembly 260, the third housing part 230 may be rotated with respect to the second hinge assembly 260. For example, when the second housing part 220 and the third housing part 230 are rotated with respect to the second hinge assembly 260, the angular displacement (or an angular change) of the second housing part 220 may be substantially the same as an angular displacement of the third housing part 230.

According to an embodiment, the first hinge assembly 250 and the second hinge assembly 260 may change a state of the electronic device. The first hinge assembly 250 and the second hinge assembly 260 may provide (or may enable) a first state 200a of the foldable electronic device 200 (or a first state 200a of the foldable housing 201). The first state 200a of the foldable electronic device 200 (or the first state 200a of the foldable housing 201) may be referred to as an unfolded state of the foldable electronic device 200 (or the foldable housing 201). In the first state 200a, a front side of the first housing part 210, a front side of the second housing part 220, and a front side of the third housing part 230 may define a front side of the foldable electronic device 200. In the first state 200a, the front side of the first housing part 210, the front side of the second housing part 220, and the front side of the third housing part 230 may face the same direction. In the first state 200a, the foldable electronic device 200 may provide a large display area of the flexible display 240 to a user.

According to an embodiment, the first hinge assembly 250 and the second hinge assembly 260 may provide a second state 200b of the foldable electronic device 200. The second state 200b of the foldable electronic device 200 may be referred to as a state in which the foldable electronic device 200 is partially folded and partially unfolded (or a single folded state or a half folded state). For example, in the second state 200b, the front side of the second housing part 220 and the front side of the third housing part 230 may face the same direction, and the front side of the first housing part 210 and the front side of the second housing part 220 may face opposite directions. For example, in the second state 200b, the first housing part 210 and the second housing part 220 may be folded, and the second housing part 220 and the third housing part 230 may be unfolded. In the second state 200b, the foldable electronic device 200 may provide visual information via a portion (e.g., a third display area 240c) of the flexible display 240.

According to an embodiment, the foldable electronic device 200 may change from the first state 200a to a third state 200c via the second state 200b. The foldable electronic device 200 may change from the first state 200a, which is the unfolded state, to the second state 200b, which is the partially unfolded state. For example, the foldable electronic device 200 may change from the first state 200a in which the first housing part 210, the second housing part 220, and the third housing part 230 face the same direction, to the second state 200b in which the front side of the first housing part 210 faces the front side of the second housing part 220. The foldable electronic device 200 may change from the second state 200b, which is the partially unfolded state, to the third state 200c, which is a folded state. For example, when changing from the second state 200b to the third state 200c, the first housing part 210 and the second housing part 220 that are folded may be disposed on the third housing part 230. The third state 200c may be referred to as a multi-folded state.

According to an embodiment, the first hinge assembly 250 and the second hinge assembly 260 may provide the third state 200c of the foldable electronic device 200 (or a third state 200c of the foldable housing 201). The third state 200c of the foldable electronic device 200 (or the third state 200c of the foldable housing 201) may be described as the folded state (or the multi-folded state) of the foldable electronic device 200 (or the foldable housing 201). In the third state 200c, the front side of the first housing part 210 and the front side of the second housing part 220 may face opposite directions, and the front side of the second housing part 220 and the front side of the third housing part 230 may face opposite directions. In the third state 200c, the front side of the first housing part 210 and the front side of the third housing part 230 may face the same direction. For example, in the third state 200c, the front side of the second housing part 220 may face the front side of the first housing part 210, and the front side of the third housing part 230 may face a rear side of the first housing part 210. In the third state 200c, a rear side of the second housing part 220 may be exposed to the outside. The display 270 may be disposed on the rear side of the second housing part 220. In the third state 200c, a rear side of the third housing part 230 may be exposed to the outside. A camera 275 may be disposed on the rear side of the third housing part 230. In the third state 200c, the foldable electronic device 200 may be folded to improve portability, and may provide visual information via the display 270 disposed on the rear side of the second housing part 220.

According to an embodiment, the foldable electronic device 200 may further include a key button 239. The key button 239 may be exposed from a structure (e.g., an opening) formed on a lateral side of the third housing part 230 and may partially protrude outside the foldable electronic device 200. The key button 239 may provide a physical input to processing circuitry inside the foldable electronic device 200 by pressure transmitted from the outside. The key button 239 may not be included in the foldable electronic device 200 and may be implemented in another form, such as a soft key displayed on the flexible display 240 or the display 270.

According to an embodiment, the key button 239 may be disposed on the lateral side of the third housing part 230 to be exposed to the outside in the third state 200c. The key button 239 may be disposed in a direction in which the lateral side of the third housing part 230 faces, by being disposed on the lateral side of the third housing part 230. Even when the foldable electronic device 200 is changed from the third state 200c to the first state 200a by a user viewing the display 270, a position of the key button 239 disposed on the lateral side of the third housing part 230 may not be moved. For example, referring to FIG. 2A, in the first state 200a, when the flexible display 240 is viewed from above, the key button 239 may be disposed on a right side. Referring to FIG. 2C, in the third state 200c, when the display 270 is viewed from above, the key button 239 may be disposed on the right side.

According to an embodiment, the flexible display 240 may at least partially define an exterior of the foldable electronic device 200. The flexible display 240 may be partially disposed in the foldable housing 201. The flexible display 240 may define the front side of the foldable electronic device 200. The flexible display 240 may include a first portion 241, a second portion 242, a third portion 243, a first bendable portion 244, and a second bendable portion 245. The first portion 241 of the flexible display 240 may be disposed on the front side of the first housing part 210. The second portion 242 of the flexible display 240 may be disposed on the front side of the second housing part 220. The third portion 243 of the flexible display 240 may be disposed on the front side of the third housing part 230. The first bendable portion 244 of the flexible display 240 may be disposed between the first portion 241 and the third portion 243 of the flexible display 240. For example, the first bendable portion 244 of the flexible display 240 may be disposed on the first hinge assembly 250 connecting the first housing part 210 and the second housing part 220. The second bendable portion 245 of the flexible display 240 may be disposed between the second portion 242 and the third portion 243 of the flexible display 240. For example, the second bendable portion 245 of the flexible display 240 may be disposed on the second hinge assembly 260 connecting the second housing part 220 and the third housing part 230.

According to an embodiment, the first hinge assembly 250 and the second hinge assembly 260 may provide the first state 200a of the foldable electronic device 200. In the first state 200a, the first portion 241 of the flexible display 240, the second portion 242 of the flexible display 240, and the third portion 243 of the flexible display 240 may face substantially a same direction. In the first state 200a, the first bendable portion 244 and the second bendable portion 245 may be disposed on substantially the same horizontal plane as the first portion 241, the second portion 242, and the third portion 243.

According to an embodiment, the first hinge assembly 250 and the second hinge assembly 260 may provide the second state 200b of the foldable electronic device 200. In the second state 200b, the first portion 241 of the flexible display 240 may face the second portion 242 of the flexible display 240, and the third portion 243 of the flexible display 240 may face the same direction as the second portion 242 of the flexible display 240. For example, the second portion 242 and the third portion 243 may be disposed on substantially the same horizontal plane.

According to an embodiment, in the second state 200b, as the first bendable portion 244 of the flexible display 240 is bent by the first hinge assembly 250, the first bendable portion 244 of the flexible display 240 may be folded such that the first portion 241 of the flexible display 240 and the second portion 242 of the flexible display 240 face different directions.

According to an embodiment, in the second state 200b, as the second bendable portion 245 of the flexible display 240 is maintained in the unfolded state by the second hinge assembly 260, the second bendable portion 245 of the flexible display 240 may be unfolded such that the second portion 242 of the flexible display 240 and the third portion 243 of the flexible display 240 face the same direction.

According to an embodiment, the first hinge assembly 250 and the second hinge assembly 260 may provide the third state 200c of the foldable electronic device 200. In the third state 200c, the second portion 242 of the flexible display 240 may face the first portion 241 of the flexible display 240, and the third portion 243 of the flexible display 240 may face the rear side of the first housing part 210.

According to an embodiment, in the third state 200c, as the first bendable portion 244 of the flexible display 240 is bent by the first hinge assembly 250, the first bendable portion 244 of the flexible display 240 may be folded such that the first portion 241 of the flexible display 240 and the second portion 242 of the flexible display 240 face different directions.

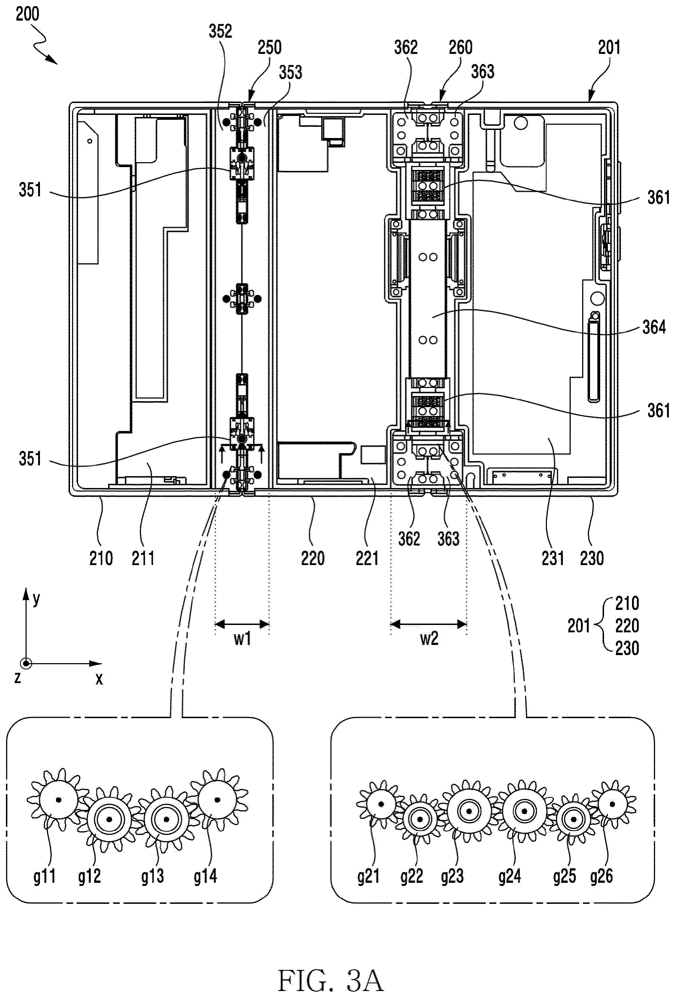

According to an embodiment, in the third state 200c, as the second bendable portion 245 of the flexible display 240 is bent by the second hinge assembly 260, the second bendable portion 245 of the flexible display 240 may be folded such that the second portion 242 of the flexible display 240 and the third portion 243 of the flexible display 240 face different directions. The second bendable portion 245 may further include a first deformation portion 245a, a second deformation portion 245b, and a planar portion 245c. The first deformation portion 245a may be disposed between the planar portion 245c and the second portion 242, and the second deformation portion 245b may be disposed between the planar portion 245c and the third portion 243. The planar portion 245c may be disposed between the first deformation portion 245a and the second deformation portion 245b. The planar portion 245c may be supported by a support plate (e.g., a support plate 364 of FIG. 3A), distinct from hinge plates (e.g., a third hinge plate 362 and a fourth hinge plate 363 of FIG. 3A) of the second hinge assembly 260. The planar portion 245c may maintain a plane regardless of a state of the foldable electronic device 200. The first deformation portion 245a and the second deformation portion 245b may be unfolded in the first state 200a and the second state 200b, and in the third state 200c, the first deformation portion 245a and the second deformation portion 245b may be bent such that the second portion 242 and the third portion 243 face different directions. In the third state 200c, the first housing part 210 may be disposed between the second housing part 220 and the third housing part 230. In the third state 200c, the second bendable portion 245 of the flexible display 240 disposed on the second hinge assembly 260 may partially face a lateral side 210c of the first housing part 210.

According to an embodiment, a display area of the flexible display 240 may include a first display area 240a, a second display area 240b, and the third display area 240c. The display area indicates an area capable of providing visual information from the flexible display 240. In the first state 200a, an entire display area of the flexible display 240 may be visible from a front side of the foldable housing 201. For example, in the first state 200a, the first display area 240a, the second display area 240b, and the third display area 240c of the flexible display 240 may be visually exposed. The foldable electronic device 200 may provide a large display area including the first display area 240a, the second display area 240b, and the third display area 240c to the user.

According to an embodiment, in the second state 200b, the display area of the flexible display 240 may be partially visible from the front side of the third housing part 230. For example, the third display area 240c may be visually exposed, and the first display area 240a and the second display area 240b may not be visually exposed.

According to an embodiment, in the third state 200c, the display area of the flexible display 240 may not be visible. For example, in the third state 200c, the first display area 240a, the second display area 240b, and the third display area 240c of the flexible display 240 may not be visually exposed.

As a non-limiting example, when the flexible display 240 is used to display a screen in the first state 200a of the foldable electronic device 200, the first display area 240a, the second display area 240b, and the third display area 240c of the flexible display 240 may be activated. As a non-limiting example, in the third state 200c, the first display area 240a, the second display area 240b, and the third display area 240c of the flexible display 240 may be deactivated. As a non-limiting example, when the flexible display 240 is used to display a screen in the second state 200b of the foldable electronic device 200, the third display area 240c may be activated, and the first display area 240a and the second display area 240b of the flexible display 240 may be deactivated.

As a non-limiting example, when the flexible display 240 is used to display a screen in the first state 200a of the foldable electronic device 200, the first display area 240a, the second display area 240b, and the third display area 240c of the flexible display 240 may display visual information. As a non-limiting example, in the third state 200c, the first display area 240a, the second display area 240b, and the third display area 240c of the flexible display 240 may provide a black image. As a non-limiting example, when the flexible display 240 is used to display a screen in the second state 200b of the foldable electronic device 200, the third display area 240c may provide visual information, and the first display area 240a and the second display area 240b of the flexible display 240 may provide a black image.

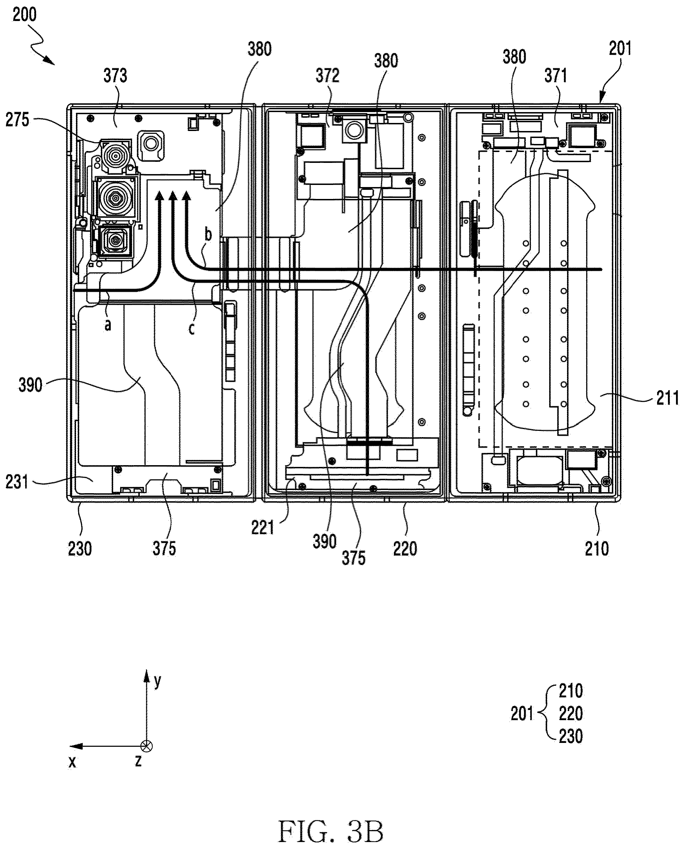

FIG. 3A is a plan view of an electronic device with a flexible display removed. FIG. 3B is a rear view of an electronic device with a rear cover and a display removed.

Referring to FIGS. 3A and 3B, a foldable electronic device 200 may include a first hinge assembly 250 and a second hinge assembly 260. A first width w1 of the first hinge assembly 250 may be narrower than a second width w2 of the second hinge assembly 260. A difference between the first width w1 of the first hinge assembly 250 and the second width w2 of the second hinge assembly 260 may be equal to or greater than a thickness of a first housing part 210. For example, the second hinge assembly 260 may have the second width w2 wider than the first width w1 such that the first housing part 210 is disposed between a second housing part 220 and a third housing part 230 according to a third state 200c. The first hinge assembly 250 may be referred to as a narrow hinge structure in terms of having a narrower width than the second hinge assembly 260. The second hinge assembly 260 may be referred to as a wide hinge structure in terms of having a wider width than the first hinge assembly 250.

According to an embodiment, the first hinge assembly 250 may include a first set 351 of gears, a first hinge plate 352, and a second hinge plate 353. The first hinge plate 352 may be coupled to a first bracket 211 of the first housing part 210. The second hinge plate 353 may be coupled to a second bracket 221 of the second housing part 220. Gears g11, g12, g13, and g14 included in the first set 351 of gears may be configured to rotate the first hinge plate 352 and the second hinge plate 353. For example, the gears g11, g12, g13, and g14 included in the first set 351 of gears may rotate the second hinge plate 353 (or the second housing part 220) in conjunction with the rotation of the first hinge plate 352 (or the first housing part 210). After the first hinge plate 352 (or the first housing part 210) is rotated, the gears g11, g12, g13, and g14 included in the first set 351 of gears may be rotated according to the rotation of the first hinge plate 352 (or the first housing part 210). The second hinge plate 353 (or the second housing part 220) may be rotated in conjunction with the rotation of the first hinge plate 352 according to the rotation of the gears included in the first set 351 of gears. The gears g11, g12, g13, and g14 included in the first set 351 of gears may include the first gear g11, the second gear g12, the third gear g13, and the fourth gear g14. The first gear g1 may be disposed adjacent to the first hinge plate 352, and the fourth gear g14 may be disposed adjacent to the second hinge plate 353. The second gear g12 and the third gear g13 may be disposed between the first gear g11 and the fourth gear g14. The first gear g11, the second gear g12, the third gear g13, and the fourth gear g14 may be sequentially engaged. According to a rotation of the first gear g11 in a first rotation direction (e.g., clockwise), the second gear g12 engaged with the first gear g11 may be rotated in a second rotation direction (e.g., counterclockwise) opposite to the first rotation direction. According to the rotation of the second gear g12 in the second rotation direction, the third gear g13 engaged with the second gear g12 may be rotated in the first rotation direction. According to the rotation of the third gear g13 in the first rotation direction, the fourth gear g14 may be rotated in the second rotation direction. As the first gear g11 and the fourth gear g14 rotate in different directions, the first housing part 210 connected to the first hinge plate 352 and the second housing part 220 connected to the second hinge plate 353 may be folded or unfolded.

According to an embodiment, the second hinge assembly 260 may include a second set 361 of gears, a third hinge plate 362, a fourth hinge plate 363, and a support plate 364. The third hinge plate 362 may be coupled to the second bracket 221 of the second housing part 220. The fourth hinge plate 363 may be coupled to a third bracket 231 of the third housing part 230. Gears g21, g22, g23, g24, g25, and g26 included in the second set 361 of gears may be configured to rotate the third hinge plate 362 and the fourth hinge plate 363. For example, the gears g21, g22, g23, g24, g25, and g26 included in the second set 361 of gears may rotate the fourth hinge plate 363 (or the third housing part 230) in conjunction with the rotation of the third hinge plate 362 (or the second housing part 220). After the third hinge plate 362 (or the second housing part 220) is rotated, the gears g21, g22, g23, g24, g25, and g26 included in the second set 361 of gears may be rotated according to the rotation of the third hinge plate 362 (or the second housing part 220). The fourth hinge plate 363 (or the third housing part 230) may be rotated in conjunction with the rotation of the third hinge plate 362 according to the rotation of the gears g21, g22, g23, g24, g25, and g26 included in the second set 361 of gears.

According to an embodiment, the gears g21, g22, g23, g24, g25, and g26 included in the second set of gears 361 may include the first gear g21, the second gear g22, the third gear g23, the fourth gear g24, the fifth gear g25, and the sixth gear g26. The first gear g21 may be disposed adjacent to the third hinge plate 362, and the sixth gear g26 may be disposed adjacent to the fourth hinge plate 363. The second gear g22, the third gear g23, the fourth gear g24, and the fifth gear g25 may be disposed between the first gear g21 and the sixth gear g26. The first gear g21, the second gear g22, the third gear g23, the fourth gear g24, the fifth gear g25, and the sixth gear g26 may be sequentially engaged. According to a rotation of the first gear g21 in the first rotation direction (e.g., clockwise), the second gear g22 engaged with the first gear g21 may be rotated in the second rotation direction (e.g., counterclockwise) opposite to the first rotation direction. According to the rotation of the second gear g22 in the second rotation direction, the third gear g23 engaged with the second gear g22 may be rotated in the first rotation direction. According to the rotation of the third gear g23 in the first rotation direction, the fourth gear g24 may be rotated in the second rotation direction. According to the rotation of the fourth gear g24 in the second rotation direction, the fifth gear g25 engaged with the fourth gear g24 may be rotated in the first rotation direction. According to the rotation of the fifth gear g25 in the first rotation direction, the sixth gear g26 engaged with the fifth gear g25 may be rotated in the second rotation direction. As the first gear g21 and the sixth gear g26 rotate in different directions, the second housing part 220 connected to the third hinge plate 362 and the third housing part 230 connected to the fourth hinge plate 363 may be folded or unfolded.

According to an embodiment, the first hinge assembly 250 and the second hinge assembly 260 may further include a spiral structure. The spiral structure having a spiral shape may include a spiral groove of a helical shape formed in each hinge plate or a rotating member connected to the hinge plate and a moving member sliding along the spiral groove. The hinge plates connected to the hinge assembly may be configured to rotate in substantially the same angular displacement via the spiral structure.

The foldable electronic device 200 according to an embodiment may include a first printed circuit board 371, a second printed circuit board 372, and a third printed circuit board 373.

According to an embodiment, the first printed circuit board 371 may be disposed in the first bracket 211 of the first housing part 210. A hardware component in the first housing part 210 may be disposed in the first printed circuit board 371. The second printed circuit board 372 may be disposed on the second bracket 221 of the second housing part 220. The third printed circuit board 373 may be disposed in the third bracket 231 of the third housing part 230. A hardware component in the third housing part 230 may be disposed in the third printed circuit board 373.

According to an embodiment, the hardware component disposed in the first printed circuit board 371 may support a hardware component disposed in the second printed circuit board 372 and/or the hardware component disposed in the third printed circuit board 373, or may operate independently.

According to an embodiment, the hardware component disposed on the second printed circuit board 372 may support the hardware component disposed on the first printed circuit board 371 or the third printed circuit board 373, or may operate independently. The hardware component disposed in the second printed circuit board 372 may include a speaker, a front camera, and/or display driver integrated circuitry.

According to an embodiment, the hardware component disposed in the third printed circuit board 373 may include at least one processor (e.g., an application processor (AP) or a communication processor (CP)) including processing circuitry, memory including one or more storage mediums, communication circuitry, and a rear camera 275. The rear camera 275 may be exposed via a rear structure (e.g., an opening) of the third housing part 230.

According to an embodiment, the foldable electronic device 200 may further include a sub-printed circuit board 375 and flexible printed circuit boards 380 and 390. The sub-printed circuit board 375 may be disposed in at least a portion of the first housing part 210, the second housing part 220, and the third housing part 230. The flexible printed circuit boards 380 and 390 may include the first flexible printed circuit board 380 and the second flexible printed circuit board 390. The first flexible printed circuit board 380 may electrically connect printed circuit boards disposed in each of the housing parts 210, 220, and 230. The second flexible printed circuit board 390 may connect a printed circuit board in the housing part in which the sub-printed circuit board 375 is disposed and the sub-printed circuit board 375.

Components in the foldable electronic device 200 may be connected to the at least one processor in the third printed circuit board 373 via the flexible printed circuit boards 380 and 390. For example, a signal received from an antenna disposed in the third housing part 230 may be transmitted to the third printed circuit board 373 in which at least one processor (e.g., the AP or the CP) is disposed via a signal path a provided by the first flexible printed circuit board 380. Driving circuitry for the flexible display 240 disposed in the first housing part 210 may be connected to the third printed circuit board 373 in which at least one processor (e.g., the AP) is disposed via a signal path b provided by the sub-printed circuit board 375 and the first flexible printed circuit board 380. Driving circuitry for a display 270 connected to the sub-printed circuit board 375 disposed in the second housing part 230 may be electrically connected to the third printed circuit board 373 in which at least one processor (e.g., the AP) is disposed via a signal path c provided by the sub-printed circuit board 375 and the first flexible printed circuit board 380 and the second flexible printed circuit board 390.

According to an embodiment, the foldable electronic device 200 may further include batteries. Each of the batteries may be attached to the brackets 211, 221, and 231 included in the housing parts 210, 220, and 230. The brackets 211, 221, and 231 may support rechargeable batteries.

A disposition of hardware components is exemplary, and differing from the above description, the rear camera 275 and the second printed circuit board 372 may be disposed in the third housing part 230, and the third printed circuit board 373 may be disposed in the second housing part 220.

The first housing part 210 and the third housing part 230 are indicated to rotate in opposite directions with respect to the second housing part 220, but are not limited thereto. For example, while changing from a first state 200a to the third state 200c, the first housing part 210 may rotate counterclockwise with respect to the second housing part 220, and the third housing part 230 may rotate counterclockwise with respect to the second housing part 220. As the first housing part 210 and the third housing part 230 rotate in the same direction, a portion of a display area of the flexible display 240 may be visually exposed in a second state.

The foldable electronic device 200 described hereinafter may be referred to as the foldable electronic device 200 described with reference to FIGS. 2A to 3B. In the following descriptions, the same reference numerals are assigned to components that are the same as the components described above, and overlapping descriptions may be omitted.

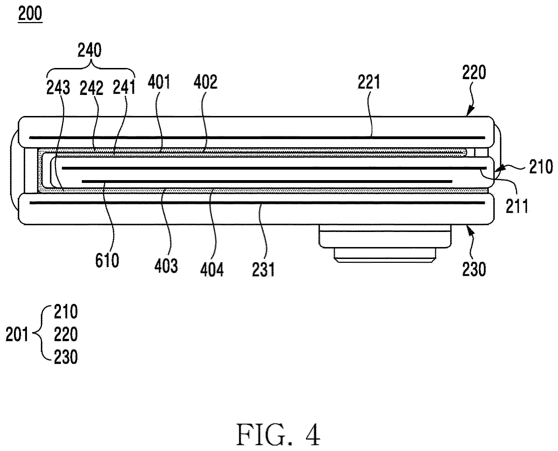

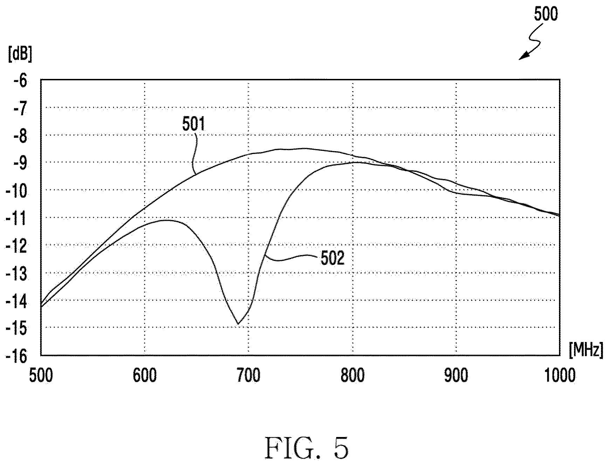

FIG. 4 illustrates a multi-folded state of a foldable electronic device. FIG. 5 indicates efficiency of an antenna of a foldable electronic device according to a frequency, according to an embodiment.

Referring to FIG. 4, a foldable electronic device 200 may be in a multi-folded state (e.g., the third state 200c of FIG. 2c). As illustrated in FIG. 4, in the multi-folded state of the foldable electronic device 200, a first housing part 210 may be positioned between a second housing part 220 a third housing part 230.

According to an embodiment, a multi-folded state of a foldable housing 201 may have a front side 402 of the second housing part 220 facing a front side 401 of the first housing part 210 and a front side 403 of the third housing part 230 facing a rear side 404 of the first housing part 210. For example, in the multi-folded state of the foldable electronic device 200, the front side 401 of the first housing part 210 and the front side 402 of the second housing part 220 may face each other, and the rear side 404 of the first housing part 210 and the front side 403 of the third housing part 230 may face each other.

According to an embodiment, a flexible display 240 may define at least a portion of a front side of the foldable housing 201. As described above, the flexible display 240 may include a first portion 241, a second portion 242, and a third portion 243. For example, the first portion 241 of the flexible display 240 may define at least a portion of the front side 401 of the first housing part 210. For example, the second portion 242 of the flexible display 240 may define at least a portion of the front side 402 of the second housing part 220. For example, the third portion 243 of the flexible display 240 may define at least a portion of the front side 403 of the third housing part 230. In the multi-folded state of the foldable electronic device 200, the first portion 241 of the flexible display 240 and the second portion 242 of the flexible display 240 may face each other. The third portion 243 of the flexible display 240 may face the rear side 404 of the first housing part 210.

According to an embodiment, the foldable electronic device 200 may include brackets corresponding to a ground of the foldable electronic device 200. For example, the first housing part 210 may include a first bracket (e.g., the first bracket 211 of FIG. 3B) corresponding to a ground of the first housing part 210. For example, the second housing part 220 may include a second bracket (e.g., the second bracket 221 of FIG. 3B) corresponding to a ground of the second housing part 220. For example, the third housing part 230 may include a third bracket (e.g., a third bracket 231 of FIG. 3B) corresponding to a ground of the third housing part 230. The first bracket 211, the second bracket 221, and the third bracket 231 may include a metal material. The first bracket 211 may be configured to function as the ground for the first housing part 210, by being disposed in the first housing part 210. The second bracket 221 may be configured to function as the ground for the second housing part 220, by being disposed in the second housing part 220. The third bracket 231 may be configured to function as the ground for the third housing part 230, by being disposed in the third housing part 230. Each of the brackets are referred to as a conductive bracket, a conductive, or a conductive support member.

As illustrated in FIG. 4, in the multi-folded state of the foldable electronic device 200, the first bracket 211, the second bracket 221, and the third bracket 231 may overlap each other. For example, in the multi-folded state of the foldable electronic device 200, the second bracket 221 in the second housing part 220 may face the first bracket 211 in the first housing part 210, and the third bracket 231 in the third housing part 230 may face the first bracket 211 in the first housing part 210.

Since a portion of the first bracket 211, the second bracket 221, and the third bracket 231 includes a metal material, they may be a conductor. When conductors face each other, a parasitic effect may be caused. For example, a parasitic capacitance formed between the conductors facing each other may cause distortion of radio frequency (RF) signals transmitted and/or received via an antenna of the foldable electronic device 200. For example, parasitic components formed in the first bracket 211, the second bracket 221, and the third bracket 231 may cause deterioration in communication performance of the foldable electronic device 200, in a case of at least partially overlapping with a frequency band of RF signals.

A graph 500 of FIG. 5 indicates efficiency of the antenna (e.g., the antenna module 197 of FIG. 1) of the foldable electronic device (e.g., the foldable electronic device 200 of FIG. 4) according to the frequency. An x-axis of the graph 500 is a frequency (unit: megahertz (MHz)), and a y-axis of the graph 500 is efficiency (unit: decibel (dB)) of the antenna. A first graph 501 indicates the efficiency of the antenna according to the frequency when the foldable electronic device 200 is in an unfolded state (e.g., the first state 200a of FIG. 2A). A second graph 502 indicates the efficiency of the antenna according to the frequency when the foldable electronic device 200 is in the multi-folded state.

Referring to the graph 500 of FIG. 5, the parasitic components formed in the first bracket (e.g., the first bracket 211 of FIG. 4), the second bracket (e.g., the second bracket 221 of FIG. 4), and the third bracket (e.g., the third bracket 231 of FIG. 4) may affect RF signals in a low band. Comparing the first graph 501 and the second graph 502, the second graph 502 indicates significantly lower efficiency than the first graph 501 at a frequency around 700 MHz and a frequency around 900 MHz. When the foldable electronic device 200 is in the multi-folded state, the parasitic components formed in the first bracket 211, the second bracket 221, and the third bracket 231 facing each other may affect an RF signal having a frequency of approximately 700 MHz and/or an RF signal having a frequency of approximately 900 MHz. For example, when a parasitic resonance by the parasitic components is formed at approximately 700 MHz or approximately 900 MHz, efficiency of an antenna for the RF signal having a frequency of about 700 MHz or the RF signal having a frequency of about 900 MHz may be reduced. As the efficiency of the antenna is reduced, the communication performance of the foldable electronic device 200 may deteriorate.

By controlling a capacitance formed between the first bracket 211, the second bracket 221, and the third bracket 231, the deterioration of the communication performance of the foldable electronic device 200 may be reduced.

Referring again to FIG. 4, in the multi-folded state of the foldable electronic device 200, the front side 401 of the first housing part 210 and the front side 402 of the second housing part 220 may face each other. For example, the first portion 241 of the flexible display 240 forming at least a portion of the front side 401 of the first housing part 210 and the second portion 242 of the flexible display 240 forming at least a portion of the front side 402 of the second housing part 220 may face each other. Since the flexible display 240 is electrically connected to the ground, controlling a capacitance formed between the first bracket 211 disposed in the first housing part 210 and the second bracket 221 disposed in the second housing part 220 may be difficult.

According to an embodiment, the foldable electronic device 200 may be configured to control a capacitance formed between the first bracket 211 in the first housing part 210 and the third bracket 231 in the third housing part 230 to shift the parasitic resonance by the parasitic component out of a frequency range of the RF signals transmitted and/or received via the antenna. The foldable electronic device 200 may control a capacitance formed in the first bracket 211 by using a plate 610 disposed between the first bracket 211 and the rear side 404 of the first housing part 210.

Hereinafter, components of the foldable electronic device 200 for controlling the capacitance are described.

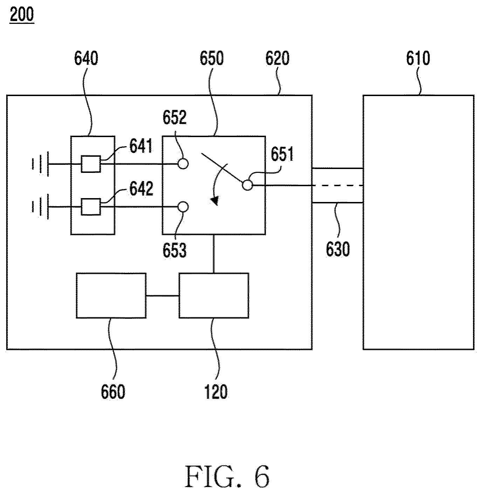

FIG. 6 is a block diagram indicating components of a foldable electronic device according to an embodiment.

Referring to FIG. 6, a foldable electronic device 200 according to an embodiment may include at least one processor 120, switch circuitry 650, impedance circuitry 640, a printed circuit board (PCB) 620, and a plate 610. As described below, the plate 610 may be referred to as one of metal structures disposed in a first housing part (e.g., the first housing part 210 of FIG. 3B).

According to an embodiment, at least one processor (e.g., the processor 120 of FIG. 1) may include processing circuitry. The at least one processor 120 may include an application processor (AP) (e.g., a central processing unit (CPU)) and/or a communication processor (CP) (e.g., a modem), but is not limited thereto. The at least one processor 120 may include a graphics processing unit (e.g., a GPU), a neural processing unit (NPU) (e.g., an artificial intelligence (AI) chip), a wireless-fidelity (Wi-Fi) chip, a Bluetooth chip, a global positioning system (GPS) chip, a near field communication (NFC) chip, connectivity chips, a sensor controller, a touch controller, a finger-print sensor controller, a display drive integrated circuit (DDI), an audio CODEC chip, a universal serial bus (USB) controller, a camera controller, an image processing IC, a microprocessor unit (MPU), a system on chip (SoC), an IC, or circuitry similar thereto.

According to an embodiment, the switch circuitry 650 may be configured to electrically and selectively connect the plate 610 to a ground (e.g., the first bracket 211 of FIG. 3B) by electrically and selectively connecting a contact 630 connected to the plate 610 and the impedance circuitry 640. The plate 610 may be electrically connected to the first bracket 211 functioning as a ground of the first housing part (e.g., the first housing part 210 of FIG. 3B) via the switch circuitry 650 and the impedance circuitry 640. When the switch circuitry 650 electrically connects the contact 630 and the impedance circuitry 640, the plate 610 may be electrically connected to the ground of the first housing part 210. When the switch circuitry 650 electrically disconnects the contact 630 and the impedance circuitry 640, the plate 610 may be electrically disconnected from the ground of the first housing part 210.

According to an embodiment, the switch circuitry 650 may include a first terminal 651 electrically connected to the contact 630 connected to the plate 610 and one or more second terminals 652 and 653 electrically connected to the impedance circuitry 640 electrically connected to the ground (e.g., the first bracket 211) of the first housing part 210. For example, the impedance circuitry 640 may be electrically connected to a ground layer of the PCB 620 that is electrically connected to the ground.

For example, in an off state (or an open state) of the switch circuitry 650 in which the first terminal 651 is electrically disconnected from the one or more second terminals 652 and 653, the contact 630 may be electrically disconnected from the impedance circuitry 640 that is electrically connected to the ground (e.g., the first bracket 211) of the first housing part 210. In the off state of the switch circuitry 650, as the contact 630 is electrically disconnected from the impedance circuitry 640, the plate 610 may be electrically disconnected from the ground of the first housing part 210.

For example, in an on state (or a closed state) of the switch circuitry 650 in which the first terminal 651 is electrically connected to the one or more second terminals 652 and 653, the contact 630 may be electrically connected to the ground (e.g., the first bracket 211) of the first housing part 210 via the switch circuitry 650 and the impedance circuitry 640. In the on state of the switch circuitry 650, as the contact 630 is electrically connected to the impedance circuitry 640, the plate 610 may be electrically connected to the ground of the first housing part 210. As described below, the at least one processor 120 may be configured to control the switch circuitry 650 to electrically connect the contact 630 and the impedance circuitry 640 based on a state (e.g., an unfolded state or a multi-folded state) of the foldable electronic device.

According to an embodiment, the impedance circuitry 640 may include a lumped element (e.g., a capacitor 641 or an inductor 642). In FIG. 6, for convenience of explanation, the impedance circuitry 640 including one capacitor 641 and one inductor 642 is illustrated, but the impedance circuitry 640 according to the present disclosure is not limited thereto. For example, the impedance circuitry 640 may include a plurality of capacitors or a plurality of inductors. For example, the impedance circuitry 640 may include a single capacitor or a single inductor. The switch circuitry 650 may be configured to electrically connect the contact 630 to one of the capacitor 641 or the inductor 642 of the impedance circuitry 640. The impedance circuitry 640 may be electrically connected to the ground layer of the PCB 620, which is electrically connected to the ground (e.g., the first bracket 211) of the first housing part 210.

According to an embodiment, a sensor 660 may be used to identify the state of the foldable electronic device 200. For example, the at least one processor 120 may be configured to identify a distance (or an angle) between the first housing part 210 and a second housing part 220 using the sensor 660. The at least one processor 120 may be configured to control the switch circuitry 650 based on the distance (or the angle) between the first housing part 210 and the second housing part 220 identified by the sensor 660. The sensor 660 may include, for example, a grip sensor, but is not limited thereto.

According to an embodiment, the foldable electronic device 200 may include the plate 610. At least a portion of the plate 610 may include a metal material (e.g., stainless steel). According to an embodiment, the plate 610 may be disposed in the first housing part 210. For example, in the first housing part 210, the plate 610 may be disposed between a first bracket (e.g., the first bracket 211 of FIG. 4) and a rear side (e.g., the rear side 404 of FIG. 4) of the first housing part.

According to an embodiment, the at least one processor 120, the switch circuitry 650, the impedance circuitry 640, and/or the sensor 660 may be disposed on the PCB 620. The PCB 620 may include a plurality of conductive layers and a plurality of non-conductive layers alternately stacked with the plurality of conductive layers. The PCB 620 may provide an electrical connection between various electronic components using wires and conductive vias formed on the plurality of conductive layers.

According to an embodiment, the foldable electronic device 200 may include the contact 630 electrically connected to the switch circuitry 650 disposed on the PCB 620. The plate 610 may be configured to electrically connect the ground layer of the PCB 620 via the contact 630, the switch circuitry 650, and the impedance circuitry 640.

According to an embodiment, the switch circuitry 650 may be configured to provide an electrical connection between the plate 610 and the ground layer of the PCB 620 by providing an electrical connection between the plate 610 and the impedance circuitry 640 based on the state of the foldable electronic device 200.

According to an embodiment, when the foldable electronic device 200 is in an unfolded state, the switch circuitry 650 may be configured to electrically disconnect the contact 630 and the impedance circuitry 640. In a state in which the contact 630 and the impedance circuitry 640 are electrically disconnected, the plate 610 may be disconnected from the ground (e.g., the first bracket 211) of the first housing part 210 by being electrically disconnected from the ground layer of the PCB 620. For example, the at least one processor 120 may be configured to control the switch circuitry 650 such that the first terminal 651 and the one or more second terminals 652 and 653 are electrically disconnected based on identifying the unfolded state of the foldable electronic device 200. As the first terminal 651 and the one or more second terminals 652 and 653 are electrically disconnected, the plate 610 may be electrically disconnected from the impedance circuitry 640, which is electrically connected to the ground layer of the PCB 620. As the plate 610 is electrically disconnected from the impedance circuitry 640, the plate 610 may be electrically disconnected from the ground (e.g., the first bracket 211) of the first housing part 210.

For example, in the unfolded state of the foldable electronic device 200, the first bracket 211 disposed in the first housing part 210, a second bracket (e.g., the second bracket 221 of FIG. 4) disposed in the second housing part (e.g., the second housing part 220 of FIG. 4) and a third bracket (e.g., the third bracket 231 of FIG. 4) disposed in a third housing part (e.g., the third housing part 230 of FIG. 4) may be disposed on substantially the same plane. Since the first bracket 211, the second bracket 221, and the third bracket 231 are disposed on substantially the same plane, a capacitance may not be formed between the brackets (e.g., the first bracket 211, the second bracket 221, and the third bracket 231 of FIG. 4). Since deterioration of communication performance of the foldable electronic device 200 by a parasitic component may not be caused as the capacitance is not formed, the plate 610 may be electrically disconnected from the impedance circuitry 640.

According to an embodiment, when the foldable electronic device 200 is in a multi-folded state, the switch circuitry 650 may be configured to electrically connect the contact 630 and the impedance circuitry 640. In a state in which the contact 630 and the impedance circuitry 640 are electrically connected, the plate 610 may be electrically connected to the ground (e.g., the first bracket 211) of the first housing part 210 by being electrically connected to the ground layer of the PCB 620. For example, the at least one processor 120 may be configured to control the switch circuitry 650 such that the first terminal 651 and the one or more second terminals 652 and 653 are electrically connected based on identifying the multi-folded state of the foldable electronic device 200. As the first terminal 651 and the one or more second terminals 652 and 653 are electrically connected, the plate 610 may be electrically connected to the impedance circuitry 640, which is electrically connected to the ground layer of the PCB 620. As the plate 610 is electrically connected to the impedance circuitry 640, the plate 610 may be electrically connected to the ground (e.g., the first bracket 211) of the first housing part 210.

For example, as described above, in the multi-folded state of the foldable electronic device 200, the first bracket 211 disposed in the first housing part 210, the second bracket 221 disposed in the second housing part 220, and the third bracket 231 disposed in the third housing part 230 may overlap each other. For example, as the first bracket 211 and the third bracket 231 face each other, a capacitance may be formed between the first bracket 211 and the third bracket 231. By the capacitance, a parasitic resonance by a parasitic component may be caused in the first bracket 211 and the third bracket 231. The parasitic resonance may deteriorate the communication performance of the foldable electronic device 200 by interfering with RF signals having a frequency in a low band. According to an embodiment, when the foldable electronic device 200 is in the multi-folded state, a capacitance of the plate 610 may be controlled as the plate 610 disposed between the first bracket 211 and the rear side of the first housing part 210 is electrically connected to the impedance circuitry 640 that is electrically connected to the first bracket 211. According to a parameter value (e.g., a capacitance or an inductance) of the lumped element of the impedance circuitry 640, an impedance of the plate 610 changes, and by the change of the impedance, a parasitic resonance of the plate 610 may shift out of the low band. As the parasitic resonance shifts out of a frequency band of the RF signals, the interference by the parasitic resonance may be reduced, and the deterioration of the communication performance of the foldable electronic device 200 in the multi-folded state may be reduced.

Hereinafter, a structure of the plate 610 disposed in the first housing part 210 is described.

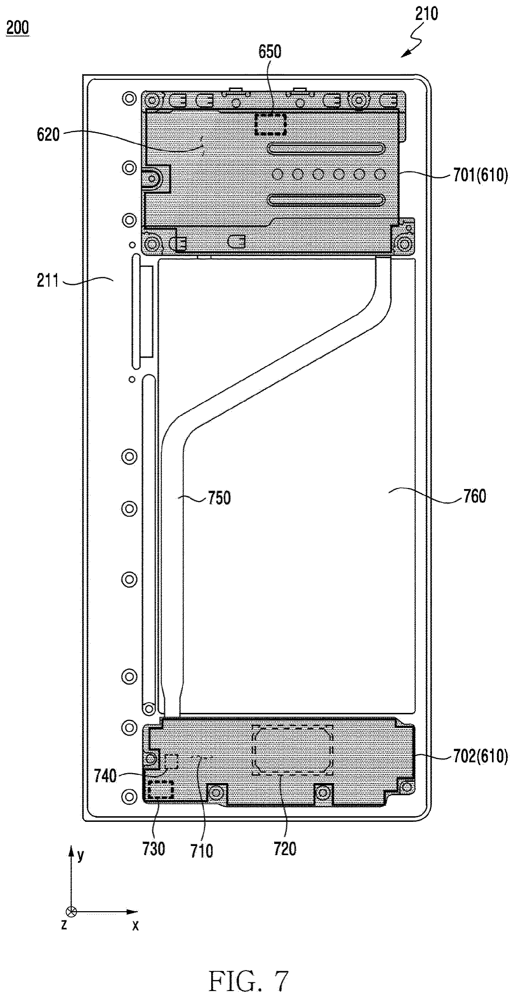

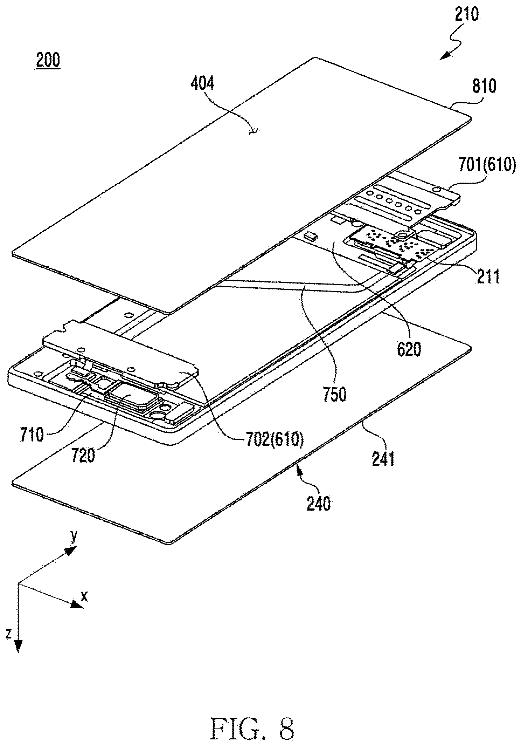

FIG. 7 illustrates the inside of a first housing part according to an embodiment. FIG. 8 is an exploded perspective view of a first housing part of FIG. 7.

Referring to FIG. 7, a first housing part 210 may include a first bracket 211, a fourth bracket 701, and/or an enclosure 702.

According to an embodiment, the fourth bracket 701 may be disposed below the first housing part 210 (e.g., a -z direction). For example, the fourth bracket 701 may be disposed between the first bracket 211 of the first housing part 210 and a rear side (e.g., the rear side 404 of FIG. 4) of the first housing part 210. The fourth bracket 701 may cover at least a portion of a printed circuit board (PCB) 620. For example, the first bracket 211 may support a side of the PCB 620, and the fourth bracket 701 may support another side of the PCB 620. For example, the fourth bracket 701 may include a metal material.

According to an embodiment, the enclosure 702 may be referred to as a case of a speaker 720. For example, the speaker 720 may be surrounded by the enclosure 702. The enclosure 702 may be configured to protect the speaker 720 disposed inside the enclosure 702 and provide a resonance space for audio signals outputted from the speaker 720. According to an embodiment, the enclosure 702 may be spaced apart from the fourth bracket 701. For example, the fourth bracket 701 may be positioned in an upper portion (e.g., a +y direction) of the first housing part 210, and the enclosure 702 may be positioned at in a lower portion of the first housing part 210.

According to an embodiment, the fourth bracket 701 and the enclosure 702 may function as the plate 610 described above. For example, a foldable electronic device 200 may use at least one of the fourth bracket 701 or the enclosure 702 disposed in the first housing part 210 to control a capacitance formed between the first bracket 211 and a third bracket (e.g., the third bracket 231 of FIG. 4) of a third housing part (e.g., the third housing part 230 of FIG. 4) in a multi-folded state of the foldable electronic device 200.

For example, in the multi-folded state of the foldable electronic device 200, in a case that a separate metal structure is added into the first housing part 210 to control the capacitance formed between the first bracket 211 of the first housing part 210 and the third bracket 231 of the third housing part 230, a thickness of the first housing part 210 may be increased or a size of other electronic components (e.g., a battery) may be reduced due to an internal space of the first housing part 210 occupied by the separate metal structure. As grounding of the separate metal structure is required to control the capacitance between the first bracket 211 and the third bracket 231, it may be difficult to form a structure for grounding the separate metal structure in the limited internal space of the first housing part 210.

According to an embodiment, the foldable electronic device 200 may use the fourth bracket 701 or the enclosure 702 included in the first housing part 210 as the plate 610 instead of the separate metal structure. As the fourth bracket 701 or the enclosure 702 included in the first housing part 210 is used as the plate 610, there is no need for a space for the separate metal structure, and thus problems in which the thickness of the first housing part 210 is increased or the size of other electronic components is reduced may be solved. According to an embodiment, another PCB 710 may be disposed in the first housing part 210. The speaker 720 may be disposed on the other PCB 710. Another switch circuitry 730 and another impedance circuitry 740 for the enclosure 702 may be disposed on the other PCB 710,.

Referring to FIG. 8, the rear side 404 of the first housing part 210 may be defined by a rear cover 810. For example, the rear cover 810 may be formed of a non-conductive material. The rear cover 810 may be opposite to a first portion 241 of a flexible display 240 that defines at least a portion of a front side of the first housing part 210.

According to an embodiment, the fourth bracket 701 may be disposed between the rear cover 810 defining the rear side of the first housing part 210 and the first bracket 211. The fourth bracket 701 may cover the PCB 620 disposed on the first bracket 211.

According to an embodiment, the foldable electronic device 200 may further include the other PCB 710 disposed in the first housing part 210. For example, the PCB 620 may be referred to as a main board of the first housing part 210, and the other PCB 710 may be referred to as a sub-board of the first housing part 210. According to an embodiment, the speaker 720 may be disposed on the other PCB 710. The enclosure 702 may at least partially cover the speaker 720 disposed on the other PCB 710 by covering the other PCB 710. The PCB 620 and the other PCB 710 may be electrically connected via a flexible printed circuit board (FPCB) 750. A battery 760 of the first housing part 210 may be disposed above (e.g., a +z direction) the FPCB 750.

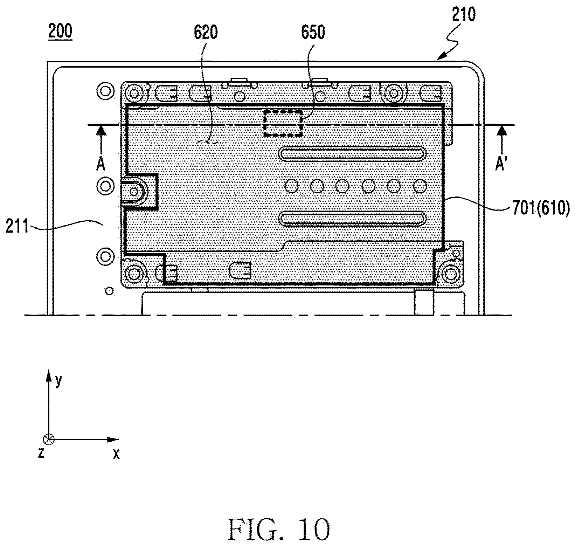

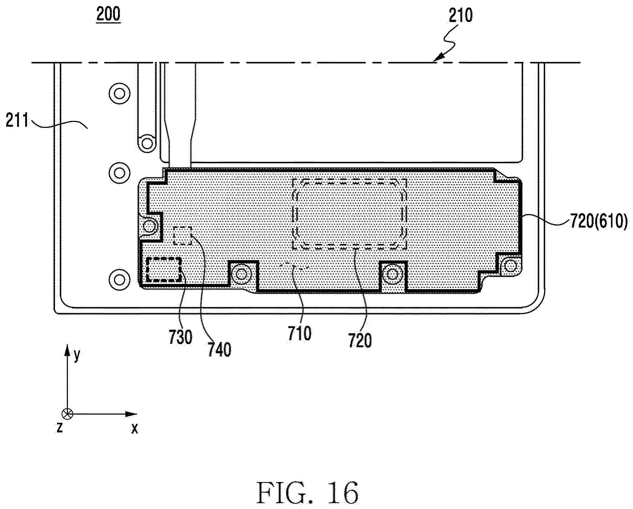

According to an embodiment, at least one of the fourth bracket 701 or the enclosure 702 may be used to control the capacitance formed between the first bracket 211 and the third bracket 231. For example, at least one of the fourth bracket 701 or the enclosure 702 may correspond to the plate 610 described above. A case that the fourth bracket 701 is used as the plate 610 will be described later with reference to FIG. 10. A case that the enclosure 702 is used as the plate 610 will be described later with reference to FIG. 16.

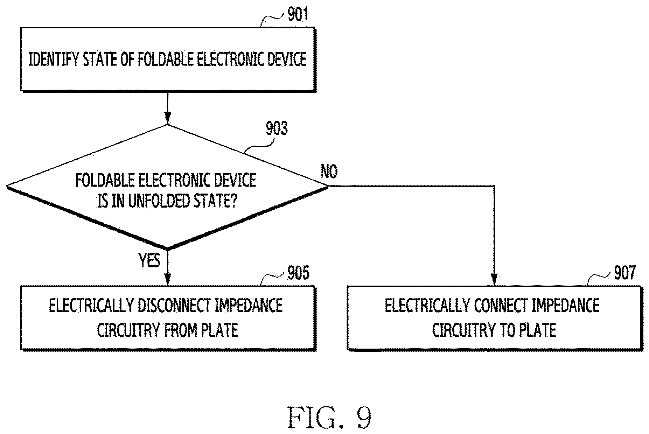

FIG. 9 is a flow chart indicating an operation of switch circuitry of a foldable electronic device according to an embodiment.

A combination of a block of a flow chart and flowcharts in the present disclosure may be performed by one or more computer programs including computer-executable instructions. For example, operations illustrated in FIG. 9 may be performed by the foldable electronic device of FIG. 6 (e.g., the foldable electronic device 200 of FIG. 6). For example, at least some of the operations may be performed by at least one processor (e.g., the at least one processor 120 of FIG. 6) of the foldable electronic device 200. For example, the operations may be referred to as operations performed by an electronic device when instructions stored in memory (e.g., the memory 130 of FIG. 1) are executed individually or collectively by the at least one processor 120.

Referring to FIG. 9, in operation 901, the foldable electronic device 200 may be configured to identify a state of the foldable electronic device 200.

According to an embodiment, the at least one processor 120 of the foldable electronic device 200 may be configured to identify the state of the foldable electronic device 200 using a sensor (e.g., the sensor 660 of FIG. 6). For example, the sensor 660 may be configured to identify an unfolded state or a multi-folded state of the foldable electronic device 200 based on a capacitance formed in each of a first bracket (e.g., the first bracket 211 of FIG. 3A) in a first housing part (e.g., the first housing part 210 of FIG. 3A), a second bracket (e.g., the second bracket 221 of FIG. 3A) in a second housing part (e.g., the second housing part 220 of FIG. 3A), and a third bracket (e.g., the third bracket 231 of FIG. 3A) in a third housing part (e.g., the third housing part 230 of FIG. 3A). As described above, the sensor 660 may include a grip sensor, but is not limited thereto. For example, the sensor 660 may include a Hall sensor that identifies a magnetic field of a magnet. In addition, the sensor 660 may include sensors capable of generating data indicating the state of the foldable electronic device 200 using various methods. The at least one processor 120 may identify the state of the foldable electronic device 200 using the sensor 660.

In operation 903, the foldable electronic device 200 may be configured to identify whether the state of the foldable electronic device 200 is the multi-folded state or the unfolded state.

According to an embodiment, the at least one processor 120 may be configured to identify whether the state of the foldable electronic device 200 identified via the operation 901 is a folded state or the unfolded state. In a case that the identified state of the foldable electronic device 200 is the unfolded state, operation 905 may be performed. In a case that the identified state of the foldable electronic device 200 is the multi-folded state, operation 907 may be performed.

In the operation 905, when the foldable electronic device 200 is in the unfolded state, the foldable electronic device 200 may be configured to electrically disconnect impedance circuitry (e.g., the impedance circuitry 640 of FIG. 6) from a plate (e.g., the plate 610 of FIG. 6).

According to an embodiment, the at least one processor 120 may be configured to control switch circuitry (e.g., the switch circuitry 650 of FIG. 6) such that the impedance circuitry 640 is electrically disconnected from the plate 610 based on identifying the unfolded state of the foldable electronic device 200. The switch circuitry 650 may be configured to electrically disconnect the impedance circuitry 640 from the plate 610 by being controlled by the at least one processor 120. For example, a first terminal (e.g., the first terminal 651 of FIG. 6) of the switch circuitry 650 electrically connected to the plate 610 may be electrically disconnected from one or more second terminals (e.g., the one or more second terminals 652 and 653 of FIG. 6) of the switch circuitry 650 electrically connected to a lumped element (e.g., the capacitor 641 or the inductor 642 of FIG. 6) of the impedance circuitry 640. When the foldable electronic device 200 is in the unfolded state, as brackets of the foldable electronic device 200 do not overlap and are disposed on substantially the same plane, a capacitance may not be formed between the brackets. Since the capacitance is not formed, controlling the capacitance of the first bracket 211 is not required, and thus the switch circuitry 650 may be configured to electrically disconnect the impedance circuitry 640 from the plate 610.

In the operation 907, when the foldable electronic device 200 is in the multi-folded state, the foldable electronic device 200 may be configured to electrically connect the impedance circuitry 640 to the plate 610.

According to an embodiment, the at least one processor 120 may be configured to control the switch circuitry 650 such that the plate 610 and the impedance circuitry 640 are electrically connected based on identifying the multi-folded state of the foldable electronic device 200. The switch circuitry 650 may be configured to electrically connect the impedance circuit 640 to the plate 610 by being controlled by the at least one processor 120. For example, the first terminal (e.g., the first terminal 651 of FIG. 6) of the switch circuitry 650 electrically connected to the plate 610 may be electrically connected to the one or more second terminals (e.g., the one or more second terminals 652 and 653 of FIG. 6) of the switch circuitry 650 electrically connected to the lumped element (e.g., the capacitor 641 or the inductor 642 of FIG. 6) of the impedance circuitry 640. As described above, the impedance circuitry 640 may be electrically connected to a ground layer of a printed circuit board (PCB) 620, which is electrically connected to the first bracket 211 corresponding to a ground of the first housing part 210. The plate 610 may be electrically connected to the first bracket 211 of the first housing part 210 via a contact 630, the switch circuitry 650, and the impedance circuitry 640. When the foldable electronic device 200 is in the multi-folded state, since the brackets of the foldable electronic device 200 overlap, a capacitance may be formed between the brackets. The switch circuitry 650 may be configured to electrically connect the impedance circuitry 640 and the plate 610 to shift a parasitic resonance caused by the capacitance out of a frequency band of RF signals transmitted and/or received via an antenna of the foldable electronic device 200.

According to an embodiment, as the plate 610 is electrically connected to the impedance circuitry 640 via the switch circuitry 650, a capacitance formed between the first bracket 211 and the third bracket (e.g., the third bracket 233 of FIG. 4) of the third housing part (e.g., the third housing part 230 of FIG. 4) may be changed. A parameter value (e.g., a capacitance or an inductance) of the lumped element (e.g., the capacitor 641 or the inductor 642 of FIG. 6) included in the impedance circuitry 640 electrically connected to the plate 610 via the switch circuitry 650 may correspond to a parameter value for shifting the parasitic resonance out of the frequency band. An impedance of the plate 610 is changed by the impedance circuitry 640, and according to the change in the impedance of the plate 610, the capacitance formed between the first bracket 211 and the third bracket 233 of the third housing part 230 may be changed. By the change in the capacitance formed between the first bracket 211 and the third bracket 233, the parasitic resonance may shift out of the frequency band. As the parasitic resonance shifts out of the frequency band, interference for the RF signals transmitted and/or received through the antenna may be reduced. According to an embodiment, deterioration of communication performance of the foldable electronic device 200 by the capacitance formed by the brackets may be reduced.

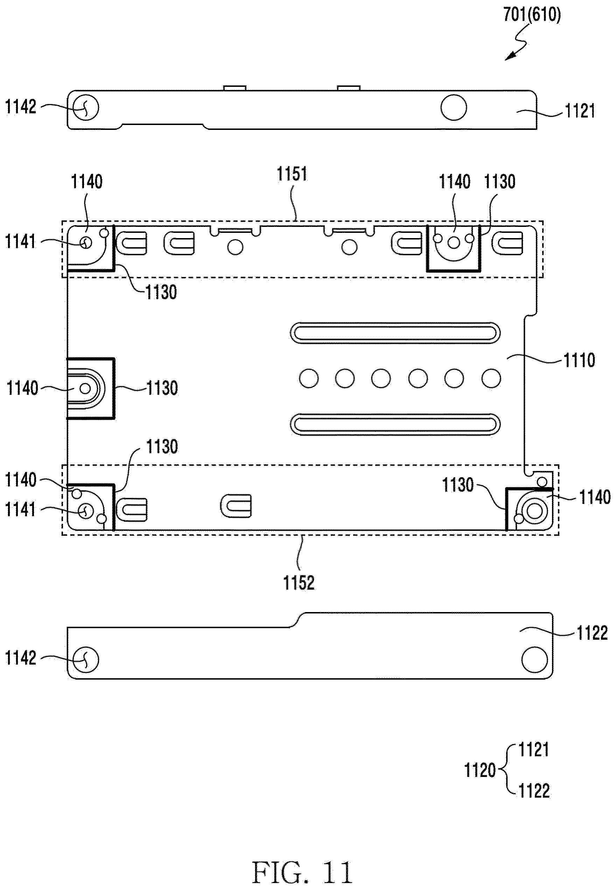

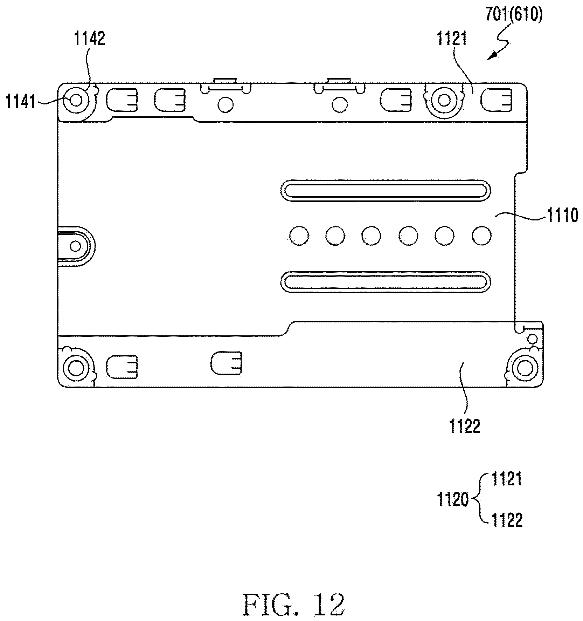

FIG. 10 illustrates an upper portion of a first housing part of a foldable electronic device according to an embodiment. FIG. 11 is an exploded view of a fourth bracket of FIG. 10. FIG. 12 is a plan view of a fourth bracket of FIG. 10.

Referring to FIG. 10, in an embodiment, a fourth bracket 701 may be used as a plate 610. Since the fourth bracket 701 covering a printed circuit board (PCB) 620 may be used as the plate 610, a capacitance formed between a first bracket 211 and a third bracket 233 of a third housing part (e.g., the third housing part 230 of FIG. 4) may be controlled even when a separate metal structure is not added to a first housing part 210. In an example illustrated in FIG. 10, the fourth bracket 701 may correspond to the plate 610. The following descriptions are described based on the plate 610 for convenience of explanation, but the plate 610 described below may correspond to the fourth bracket 701 of FIG. 10.

Referring to FIG. 11, the plate 610 may include a conductive portion 1110 and a non-conductive portion 1120. The conductive portion 1110 may be spaced apart from the first bracket (e.g., the first bracket 211 of FIG. 10) corresponding to a ground of the first housing part (e.g., the first housing part 210 of FIG. 10). For example, the conductive portion 1110 may be floated with respect to the first bracket 211. For example, the non-conductive portion 1120 may be contacted with the first bracket 211 to support the plate 610.

Referring to FIGS. 11 and 12, a manufacturing process of the plate 610 (e.g., the fourth bracket 701) is described. Referring to FIG. 11, the conductive portion 1110 of the plate 610 may be manufactured. For example, the conductive portion 1110 of the plate 610 may have a substantially rectangular parallelepiped shape. After the conductive portion 1110 is manufactured, a portion of a peripheral portion of the conductive portion 1110 may be cut. The cut portion of the peripheral portion of the conductive portion 1110 may be referred to as a cut portion 1130. A partial area 1140 surrounded by the cut portion 1130 may be insulated from the conductive portion 1110 by the cut portion 1130.

By injecting a non-conductive material into the conductive portion 1110 having the cut portion 1130, the non-conductive portion 1120 of the plate 610 may be formed. The non-conductive portion 1120 of the plate 610 may be formed on a portion of a peripheral portion of the conductive portion 1110. For example, the conductive portion 1110 having the cut portion 1130 may be put into a mold, and a non-conductive material in a semi-solid state or a liquid state may be injected into a cavity inside the mold. The injected non-conductive material may flow on both sides of the peripheral portion of the conductive portion 1110 via the cut portion 1130. As the non-conductive material is cured, after the injection of the non-conductive material is completed, the non-conductive portion 1120 of the plate 610 may be formed. Since the non-conductive material may be introduced into the cut portion 1130, the cut portion 1130 may be filled with the non-conductive portion 1120, when the non-conductive material is cured. For example, the non-conductive portion 1120 may include a first non-conductive portion 1121 formed on a first peripheral portion 1151 of the conductive portion 1110 and a second non-conductive portion 1122 formed on a second peripheral portion 1152 of the conductive portion 1110 opposite to the first peripheral portion 1151. The second non-conductive portion 1122 may be opposite to the first non-conductive portion 1121.

According to an embodiment, the conductive portion 1110 may include a first through hole 1141 disposed in the portion of the peripheral portion. When the non-conductive portion 1120 is injected, the non-conductive portion 1120 may include a second through hole 1142 aligned with the first through hole 1141. For example, a cavity of a mold to form the non-conductive portion 1120 may have a shape to form the second through hole 1142.

Referring to FIG. 12, when the non-conductive portion 1120 is formed and the plate 610 is manufactured, the first through hole 1141 and the second through hole 1142 may be aligned with each other. A fastener for coupling the plate 610 to the first bracket (e.g., the first bracket 211 of FIG. 10) of the first housing part 210 may be inserted into the first through hole 1141 and the second through hole 1142. For example, the fastener may include a screw, but is not limited thereto. As the fastener passes through the first through hole 1141 and the second through hole 1142, and is coupled to the first bracket 211, the plate 610 may be coupled to the first bracket 211 via the fastener. Since the first through hole 1141 is formed in the portion of the peripheral portion of the conductive portion 1110 in which the non-conductive portion 1120 is formed, the non-conductive portion 1120 of the plate 610 may be contacted with the first bracket 211, and the conductive portion 1110 of the plate 610 may be spaced apart from the first bracket 211.

The manufacturing process of the plate 610 illustrated in FIGS. 11 and 12 is only exemplary, and embodiments of the present disclosure are not limited thereto. For example, the plate 610 may include a plate on which a metal sheet or a conductive paint is deposited. For example, the plate 610 may be manufactured by depositing the conductive paint on a non-conductive plate. In addition, the plate 610 may be manufactured via various methods.

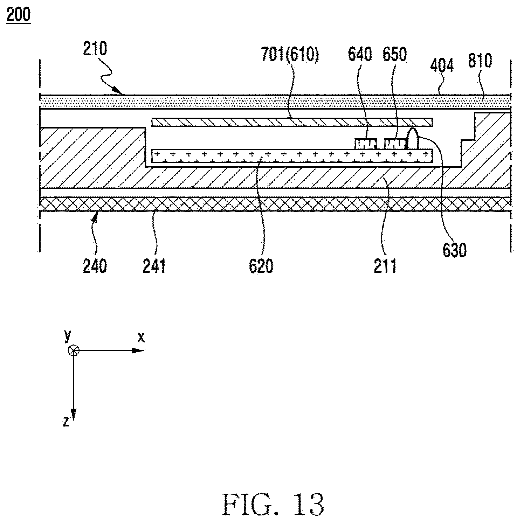

FIG. 13 is a cross-sectional view of a foldable electronic device according to an embodiment, cut along line A-A' of FIG. 10.

Referring to FIG. 13, a conductive portion (e.g., the conductive portion 1110 of FIG. 11) of a plate 610 (e.g., the fourth bracket 701) may be spaced apart from a first bracket 211. Although not illustrated in FIG. 13, the plate 610 may be coupled to the first bracket 211 via a fastening member inserted into the first bracket 211 by penetrating a non-conductive portion (e.g., the non-conductive portion 1120 of FIG. 1120) and the conductive portion 1110. The plate 610 may be fastened by being coupled to the first bracket 211. The plate 610 may be disposed between the first bracket 211 and a rear side 404 of the first housing part 210. For example, the plate 610 may be disposed between the first bracket 211 and a rear cover 810 defining the rear side 404 of the first housing part 210.

According to an embodiment, the plate 610 may be electrically connected to a printed circuit board (PCB) 620 via switch circuitry 650 that is electrically connected to a contact 630 and impedance circuitry 640. The PCB 620 may be disposed on the first bracket 211. For example, the PCB 620 may be disposed in a side of the first bracket 211, and a first portion 241 of a flexible display 240 may be disposed in another side of the first bracket 211.

According to an embodiment, the switch circuitry 650 and the impedance circuitry 640 may be disposed on the PCB 620. For example, the switch circuitry 650 may be configured to provide an electrical connection between the plate 610 and the impedance circuitry 640 based on a state of a foldable electronic device 200. According to an embodiment, when the foldable electronic device 200 is in an unfolded state, the switch circuitry 650 may be configured to electrically disconnect the impedance circuitry 640 from the plate 610. For example, when the foldable electronic device 200 is in the unfolded state, the switch circuitry 650 may be configured to operate in an off state (or an open state) in which a first terminal (e.g., the first terminal 651 of FIG. 6) and one or more second terminals (e.g., the one or more second terminals 652 and 653 of FIG. 6) are electrically disconnected. When the foldable electronic device 200 is in a multi-folded state, the switch circuitry 650 may be configured to electrically connect the plate 610 and the impedance circuitry 640. For example, when the foldable electronic device 200 is in the multi-folded state, the switch circuitry 650 may be configured to operate in an on state (or a closed state) in which the first terminal (e.g., the first terminal 651 of FIG. 6) and the one or more second terminals 652 and 653 are electrically connected. When the plate 610 disposed between the first bracket 211 and the rear side 404 of the first housing part 210 is electrically connected to the impedance circuitry 640 by the switch circuitry 650, a capacitance formed between the first bracket 211 and a third bracket (e.g., the third bracket 231 of FIG. 4) may be changed. The capacitance may be based on a parameter value (e.g., a capacitance or an inductance) of a lumped element (e.g., the capacitor 641 or the inductor 642 of FIG. 6) of the impedance circuitry 640. According to an embodiment, the parameter value of the lumped element may be referred to as a value for shifting a parasitic resonance caused by a capacitance formed in the first bracket 211 out of a frequency band of RF signals transmitted and/or received via an antenna of the foldable electronic device 200.

According to an embodiment, the capacitor 641 or the inductor 642 of the impedance circuitry 640 may include a variable capacitor or a variable inductor. The variable capacitor or the variable inductor may not have a fixed capacitance or inductance, but may have a changeable capacitance or inductance. The foldable electronic device 200 may be configured to adjust the capacitance of the variable capacitor or the inductance of the variable inductor such that a parasitic component does not interfere with the frequency band of the RF signals.

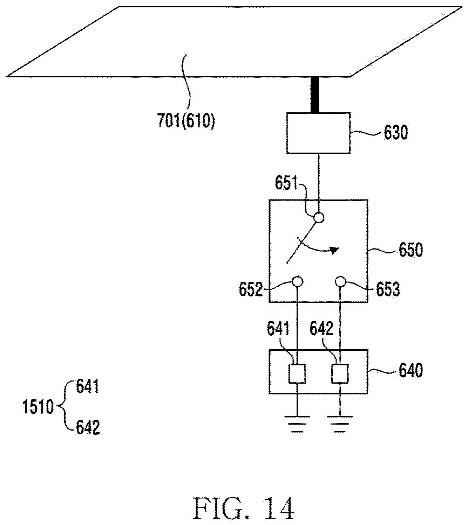

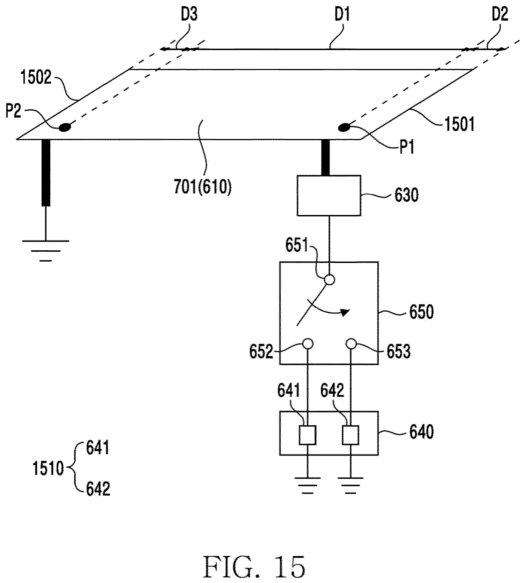

FIGS. 14 and 15 illustrate a plate.

Referring to FIG. 14, a plate 610 (e.g., the fourth bracket 701) may be electrically connected to a first bracket (e.g., the first bracket 211 of FIG. 7) corresponding to a ground of a first housing part (e.g., the first housing part 210 of FIG. 7) via a contact 630, switch circuitry 650, and impedance circuitry 640. For example, a printed circuit board (PCB) 620 may include a ground layer electrically connected to the first bracket 211. A lumped element 1510 (e.g., a capacitor 641 or an inductor 642) of the impedance circuitry 640 may be electrically connected to the ground layer of the PCB 620. The switch circuitry 650 may include a first terminal 651 electrically connected to the contact 630 and one or more second terminals 652 and 653 electrically connected to the lumped element 1520. For example, the impedance circuitry 640 may include the capacitor 641 and/or the inductor 642, and the one or more second terminals 652 and 653 of the switch circuitry 650 may include the terminal 652 electrically connected to the capacitor 641 and the terminal 653 electrically connected to the inductor 642. The impedance circuitry 640 illustrated in FIG. 15 is only exemplary, and examples of the present disclosure are not limited thereto. The lumped element 1510 of the impedance circuitry 640 may be electrically connected to the ground layer of the PCB 620 that is electrically connected to the first bracket 211 corresponding to the ground of the first housing part 210.

According to an embodiment, the switch circuitry 640 may be configured to electrically connect the plate 610 to the first bracket 211 by electrically connecting the contact 630 to the impedance circuitry 640. For example, in an on state (or a closed state) of the switch circuitry 650 in which the first terminal 651 and the one or more second terminals 652 and 653 are electrically connected, the contact 630 may be electrically connected to the first bracket 211 via the impedance circuitry 640 and the ground layer of the PCB 620. The plate 610 may be electrically connected to the first bracket 211 via the contact 630 electrically connected to the first bracket 211.

Referring to FIG. 15, the plate 610 may be electrically connected to the first bracket (e.g., the first bracket 211 of FIG. 7) corresponding to the ground of the first housing part (e.g., the first housing part 210 of FIG. 7). For example, a first point P1 of the plate 610 may be electrically connected to the first bracket 211 via the contact 630, the switch circuitry 650, and the impedance circuitry 640. A second point P2 of the plate 610 may be electrically connected to the first bracket 211. For example, the first point P1 of the plate 610 may be adjacent to a first lateral side 1501 of the plate 610, and the second point P2 of the plate 610 may be adjacent to a second lateral side 1502 of the plate 610. The second lateral side 1502 of the plate 610 may be adjacent to a first hinge assembly (e.g., the first hinge assembly 250 of FIG. 2A) rotatably connecting the first housing part 210 and a second housing part (e.g., the second housing part 220 of FIG. 2A). For example, a first hinge assembly 250 may be closer to the second point P2 of the plate 610 than the first point P1 of the plate 610. For example, the first point P1 and the second point P2 may be positioned spaced apart from each other to be adjacent to each periphery positioned opposite to each other on the plate 610.

According to an embodiment, an impedance of the plate 610 may be changed via the switch circuitry 650 and the impedance circuitry 640 to adjust a capacitance formed in the first bracket 211. An area in which the impedance of the plate 610 is changed may be spaced far from the second point P2 electrically connected to the first bracket 211 corresponding to the ground. For example, since an area of the plate 610 around the second point P2, which is electrically connected to the first bracket 211, is electrically connected to the first bracket 211, it may be impossible to change the impedance by the switch circuitry 650 and the impedance circuitry 640 or it may be difficult to change the impedance. For example, in an area around the first point P1 electrically connected to the PCB 620 via the contact 630, the impedance may be easily changed by the impedance circuitry 640 and the switch circuitry 650. To adjust the capacitance formed in the first bracket 211, the first point P1 may be far from the second point P2 such that the area around the first point P1 in which the impedance is easily changed may be secured.

According to an embodiment, a distance between the first point P1 of the plate 610 and the second point P2 of the plate 610 may be referred to as a first distance D1. A distance between the first point P1 of the plate 610 and the first lateral side 1501 of the plate 610 adjacent to the first point P1 may be referred to as a second distance D2. A distance between the second point P2 of the plate 610 and the second lateral side 1502 of the plate 610 adjacent to the second point P2 may be referred to as a third distance D3. According to an embodiment, the first distance D1 may be longer than the second distance D2 and the third distance D3. As the first distance D1 is formed longer than the second distance D2 and the third distance D3, a distance between the first point P1 and the second point P2 may be formed relatively long. As the first point P1 is far from the second point P2, the area of the plate 610 around the first point P1 in which the impedance is easily changed may be secured. As the area of the plate 610 around the first point P1 is secured, the capacitance of the first bracket 211 may be adjusted by the change in the impedance of the plate 610.

FIG. 16 illustrates a lower portion of a first housing part of a foldable electronic device according to an embodiment.

Referring to FIG. 16, an enclosure 702 disposed in the lower portion (e.g., a -y direction) of a first housing part 210 may be disposed. The enclosure 702 may be disposed between a first bracket 211 and a rear side (e.g., the rear side 404 of FIG. 4 or a rear cover 810) of the first housing part 210.

According to an embodiment, another printed circuit board (PCB) 710 may be disposed in an lower portion of the first bracket 211. A speaker 720 may be disposed on the other PCB 710. The enclosure 702 may be configured to protect the speaker 720 and provide a resonance space for an audio signal outputted from the speaker 720 by at least partially covering the speaker 720. In a multi-folded state of the foldable electronic device 200, the enclosure 702 may be used as a plate 610 to adjust a capacitance between the first bracket 211 and a third bracket (e.g., the third bracket 231 of FIG. 4) of a third housing part (e.g., the third housing part 230 of FIG. 4). The following descriptions are described based on the plate 610 for convenience of explanation, but the plate 610 described below may correspond to the enclosure 702 of FIG. 16.

According to an embodiment, another switch circuitry 730 and another impedance circuitry 740 may be disposed on the other PCB 710. The other switch circuitry 730 may be configured to provide an electrical connection between the plate 610 and the other impedance circuitry 740 based on a state of the foldable electronic device 200. The other impedance circuitry 740 may be electrically connected to a ground layer of the other PCB 710 that is electrically connected to the first bracket 211 corresponding to a ground of the first housing part 210.

According to an embodiment, when the foldable electronic device 200 is in an unfolded state, the other switch circuitry 740 may be configured to electrically disconnect the other impedance circuitry 740 from the plate 610. When the foldable electronic device 200 is in the multi-folded state, the other switch circuitry 730 may be configured to electrically connect the plate 610 and the other impedance circuitry 740. When the plate 610 disposed between the first bracket 211 and the rear side of the first housing part 210 is electrically connected to the other impedance circuitry 740 by the other switch circuitry 730, the plate 610 may be electrically connected to the first bracket 211 via the other switch circuitry 730 and the other impedance circuitry 740. As the plate 610 is electrically connected to the first bracket 211, the capacitance formed between the first bracket 211 and the third bracket 231 may be changed. The capacitance may be based on a parameter value (e.g., a capacitance or an inductance) of a lumped element (e.g., a capacitor or an inductor) of the other impedance circuitry 740. According to an embodiment, the parameter value of the lumped element may be referred to as a value for shifting a parasitic resonance caused by the capacitance formed in the first bracket 211 out of a frequency band of RF signals transmitted and/or received via an antenna of the foldable electronic device 200.

According to an embodiment, the foldable electronic device 200 may use at least one of a fourth bracket (e.g., the fourth bracket 701 of FIG. 7) or the enclosure 702 as the plate 610. As described above, an impedance of the plate 610 may be changed by an electrical connection of the plate 610 and the impedance circuitry (e.g., the impedance circuitry 640 of FIG. 6 or the other impedance circuitry 740 of FIG. 16). By the change in the impedance of the plate 610, the capacitance formed between the first bracket 211 and the third bracket 231 in the multi-folded state of the foldable electronic device 200 may be adjusted. According to an embodiment, the foldable electronic device 200 may shift the parasitic resonance out of the frequency band of the RF signals by adjusting the capacitance formed between the first bracket 211 and the third bracket 231 in the multi-folded state. According to an embodiment, deterioration of communication performance of the foldable electronic device 200 may be reduced.

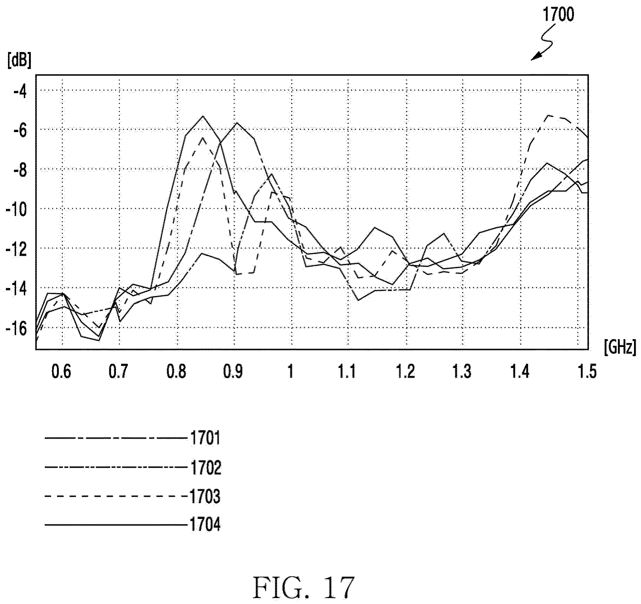

FIG. 17 is a graph indicating efficiency of an antenna of a foldable electronic device according to a frequency, according to an embodiment.

An x-axis of a graph 1700 of FIG. 17 is a frequency (unit: GHz), and a y-axis of the graph 1700 is efficiency (unit: dB) of an antenna. A first graph 1701 indicates the efficiency of the antenna according to the frequency when a foldable electronic device 200 is in an unfolded state. A second graph 1702 indicates the efficiency of the antenna according to the frequency in a case that the foldable electronic device 200 is in a multi-folded state and impedance circuitry 640 and a fourth bracket 701 or an enclosure 702 are electrically disconnected. A third graph 1703 indicates the efficiency of the antenna according to the frequency in a case that the foldable electronic device 200 is in the multi-folded state and one of the fourth bracket 701 or the enclosure 702 is electrically connected to a ground (e.g., the first bracket 211 of FIG. 4) of a first housing part (e.g., the first housing part 210 of FIG. 4) via a capacitor 641 having 1pF of the impedance circuitry 640. A fourth graph 1704 indicates the efficiency of the antenna according to the frequency when the foldable electronic device 200 is in the multi-folded state and both the fourth bracket 701 and the enclosure 702 are electrically connected to the ground (e.g., the first bracket 211 of FIG. 4) of the first housing part 210 via the capacitor 641 having 1pF of the impedance circuitry 640.

Comparing the first graph 1701 and the second graph 1702, as the foldable electronic device 200 is changed from the unfolded state to the multi-folded state, the efficiency of the antenna may be reduced. For example, the efficiency of the antenna indicated by the first graph 1701 for a frequency of approximately 0.8 GHz to approximately 0.9 GHz is approximately - 6 dB, and the efficiency of the antenna indicated by the second graph 1702 for the frequency of approximately 0.8 GHz to approximately 0.9 GHz, is approximately -13 dB. As the state of the foldable electronic device 200 is changed from the unfolded state to the multi-folded state, the efficiency of the antenna may be reduced by approximately 7 dB. As described above, when the foldable electronic device 200 is in the multi-folded state, a parasitic resonance may be caused due to overlapping of the first bracket 211, a second bracket 221, a third bracket 231. Since the parasitic resonance may at least partially overlap a frequency band of RF signals transmitted and/or received via the antenna, the efficiency of the antenna may be reduced.

Referring to the third graph 1703, as one of the fourth bracket 701 and the enclosure 702 is used as a plate 610 electrically connected to the first bracket 211 via the impedance circuitry 640, the efficiency of the antenna may be improved. When the plate 610 corresponding to one of the fourth bracket 701 or the enclosure 702 is electrically connected to the first bracket 211 via the capacitor 641 having 1pF, an impedance of the plate 610 may be changed. According to the change in the impedance of the plate 610, in the multi-folded state of the foldable electronic device 200, a capacitance between the first bracket 211 and the third bracket 231 may be changed. As the parasitic resonance may shift by the change in the capacitance between the first bracket 211 and the third bracket 231, interference for the antenna may be reduced. As the interference for the antenna is reduced, the efficiency of the antenna may be improved. For example, the efficiency of the antenna indicated by the third graph 1703 for the frequency of approximately 0.8 GHz to approximately 0.9 GHz is approximately -7 dB. When the foldable electronic device 200 is in the multi-folded state, as one of the fourth bracket 701 or the enclosure 702 is used as the plate 610, the efficiency of the antenna may be improved from approximately -13 dB to approximately -7 dB.

Referring to the fourth graph 1704, the efficiency of the antenna may be improved as both the fourth bracket 701 and the enclosure 702 are used as the plate 610 electrically connected to the first bracket 211 via the impedance circuitry 640. When each of the fourth bracket 701 and the enclosure 702 is electrically connected to the first bracket 211 via the capacitor 641 having 1pF, an impedance of the fourth bracket 701 and an impedance of the enclosure 702 may be changed. According to the change in the impedance, in the multi-folded state of the foldable electronic device 200, the capacitance between the first bracket 211 and the third bracket 231 may be changed. As the parasitic resonance may shift by the change in the capacitance between the first bracket 211 and the third bracket 231, the interference for the antenna may be reduced. As the interference for the antenna is reduced, the efficiency of the antenna may be improved. For example, the efficiency of the antenna indicated by the fourth graph 1704 for the frequency of approximately 0.8 GHz to approximately 0.9 GHz is approximately -6 dB. In a case that the fourth bracket 701 and the enclosure 702 are used as the plate 610 when the foldable electronic device 200 is in the multi-folded state, communication performance of the foldable electronic device 200 in the multi-folded state may be provided at a level substantially equivalent to communication performance of the foldable electronic device 200 in the unfolded state. For example, in a frequency range between approximately 0.8 GHz and approximately 0.9 GHz, the communication performance of the foldable electronic device 200 in the multi-folded state may be substantially the same as or similar to the communication performance of the foldable electronic device 200 in the unfolded state.

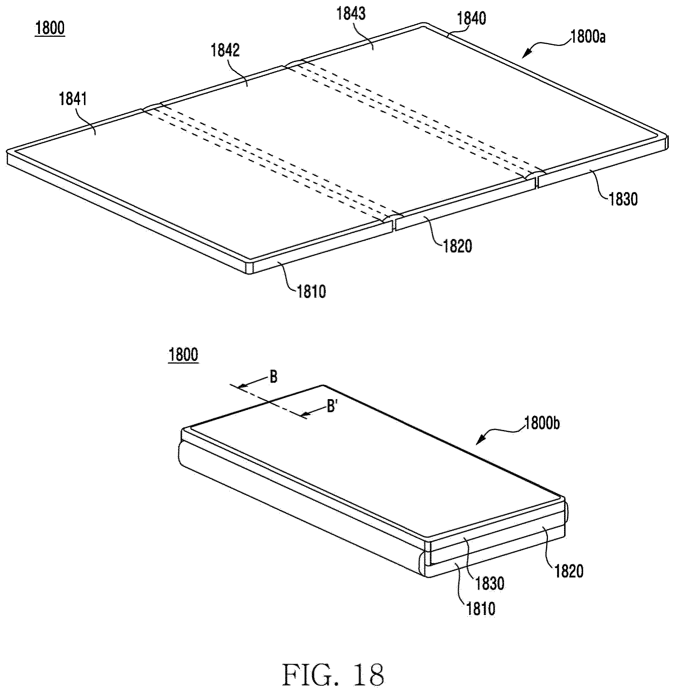

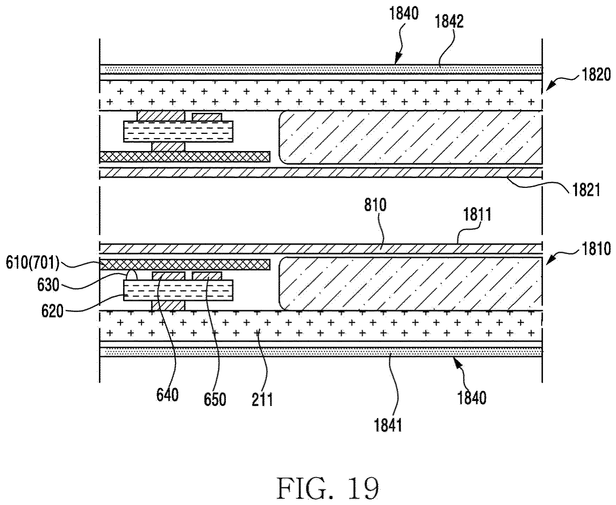

The foldable electronic device 200 described above is illustrated in a structure in which a first rotation direction of the first housing part 210 with respect to a second housing part 220 and a second rotation direction of a third housing part 230 with respect to the second housing part 220 are opposite to each other, but embodiments of the present disclosure are not limited thereto. An operation of adjusting a capacitance of the first bracket 211 using the plate 610, the switch circuitry 650, and matching circuitry may be substantially equally applied to various multi-fold electronic devices including three housing parts. In a case of a foldable electronic device 1800 described with reference to FIGS. 18 and 19, the first rotation direction and the second rotation direction may have the same structure.

FIG. 18 illustrates a foldable electronic device according to an embodiment. FIG. 19 is a cross-sectional view of a foldable electronic device according to an embodiment, cut along line B-B' of FIG. 18.

Referring to FIG. 18, a foldable electronic device 1800 may include a first housing part 1810, a second housing part 1820, and a third housing part 1830.

According to an embodiment, when the foldable electronic device 1800 is in an unfolded state (e.g., a state 1800a of FIG. 18), the first housing part 1810, the second housing part 1820, and the third housing part 1830 may be disposed on substantially the same plane. In the unfolded state of the foldable electronic device 1800, a first portion 1841 of a flexible display 1840, a second portion 1842 of the flexible display 1840, and a third portion 1843 of the flexible display 1840 may face substantially the same direction.

According to an embodiment, in the foldable electronic device 1800 in the unfolded state, as the third housing part 1830 rotates counterclockwise with respect to the second housing part 1820 and the first housing part 1810 rotates counterclockwise with respect to the second housing part 1820, a state of the foldable electronic device 1800 may change from the unfolded state to a folded state.

The descriptions related to the plate 610 described above may be substantially equally applied to the foldable electronic device 1800 illustrated in FIG. 18. For example, when the foldable electronic device 1800 is in a multi-folded state (e.g., a state 1800b of FIG. 18), a front side of the second housing part 1820 may face a front side of the third housing part 1830, and a rear side of the first housing part 1810 may face a rear side of the second housing part 1820. The second portion 1842 of the flexible display 1840 forming at least a portion of the front side of the second housing part 1820 may face the third portion 1843 of the flexible display 1840 forming at least a portion of the front side of the third housing part 1830. Since the second portion 1842 and the third portion 1843 face each other, it may be difficult to apply the above-described plate 610 to the second housing part 1820 and the third housing part 1830. According to an embodiment, the above-described plate (e.g., a plate 610 of FIG. 19) may be applied to the first housing part 1810 facing the rear side of the second housing part 1820 or the second housing part 1820 facing a rear side of the first housing part 1810.

Referring to FIG. 19, the first housing part 1810 may include a first bracket 211 and a fourth bracket 701. The fourth bracket 701 may be disposed between the first bracket 211 and a rear side 1811 of the first housing part 1810. For example, the fourth bracket 701 may be disposed between the first bracket 211 and a rear cover 810 defining the rear side 1811 of the first housing part 1810. The rear side 1811 of the first housing part 1810 may face a rear side 1821 of the second housing part 1820. The rear side 1811 of the first housing part 1810 may be opposite to the first portion 1841 of the flexible display 1840.

According to an embodiment, the fourth bracket 701 may be used as the plate 610. For example, the fourth bracket 701 may be electrically connected to a printed circuit board (PCB) 620 disposed in the first housing part 1810 via a contact 630. The fourth bracket 701 may be electrically connected to impedance circuitry 640 via switch circuitry 650 disposed on the PCB 620. The switch circuitry 650 may be configured to electrically connect the impedance circuitry 640 to the fourth bracket 701 when the foldable electronic device 1800 is in the multi-folded state. The switch circuitry 650 may be configured to electrically disconnect the impedance circuitry 640 from the fourth bracket 701 when the foldable electronic device 1800 is in the unfolded state. Although not illustrated, an enclosure (e.g., the enclosure 702 of FIG. 7) surrounding a speaker (e.g., the speaker 720 of FIG. 7) disposed in the first housing part 1810 may be used as the plate 610.

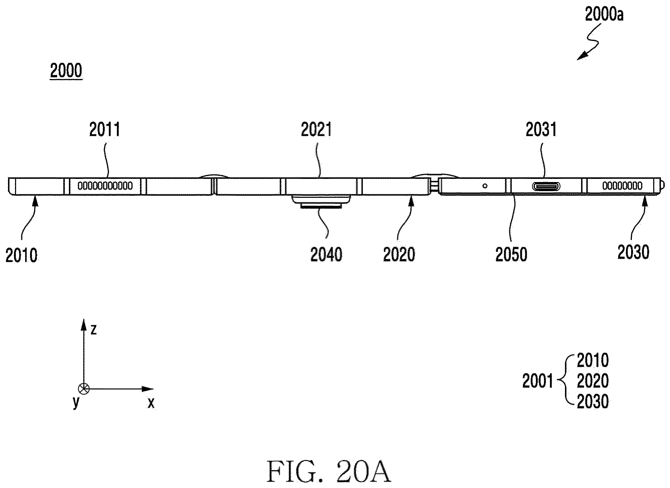

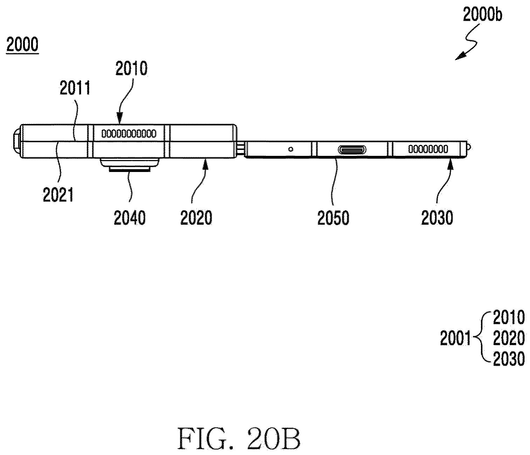

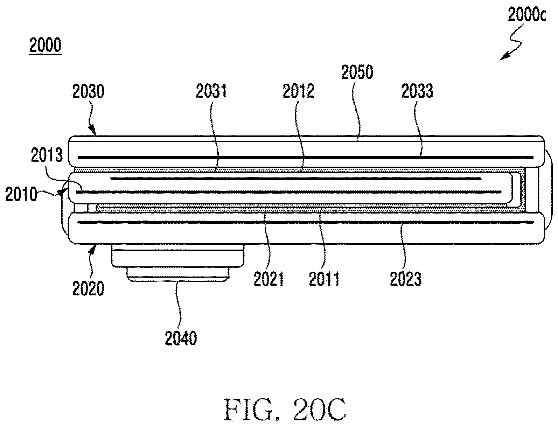

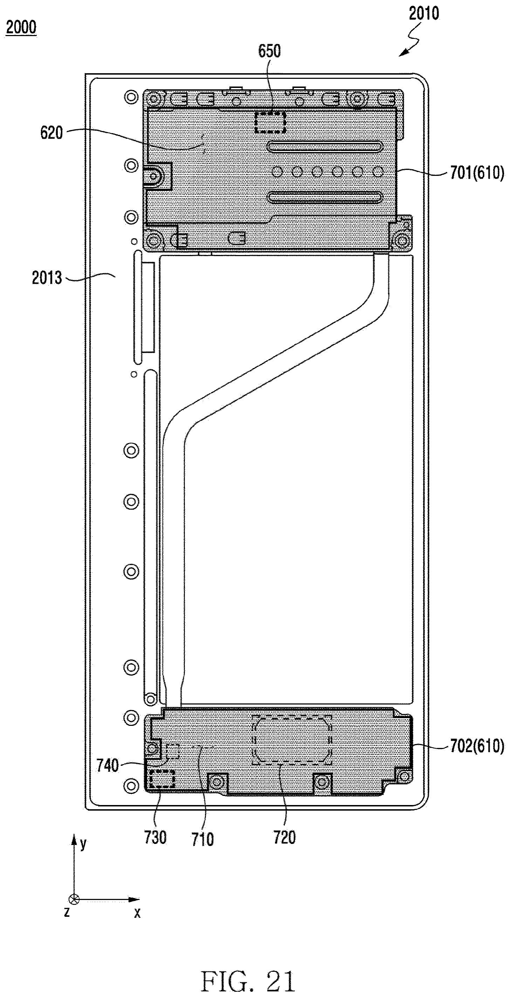

FIG. 20A illustrates an example of a first state of an electronic device. FIG. 20B illustrates an example of a second state of an electronic device. FIG. 20C illustrates an example of a third state of an electronic device. FIG. 21 illustrates the inside of a first housing part according to an embodiment.

In a case of the foldable electronic device 200 described with reference to FIGS. 2A, 2B, and 2C, the foldable electronic device 200 is described in which a camera (e.g., the camera 275 of FIG. 2A) is disposed on a rear side of a third housing part 230, and a display (e.g., the display 270 of FIG. 2C) is disposed on a rear side of a second housing part 220, but examples of the present disclosure are not limited thereto.

Referring to FIGS. 20A, 20B, and 20C, a foldable electronic device 2000 may include a foldable housing 2001 including a first housing part 2010, a second housing part 2020, and a third housing part 2030. The foldable electronic device 2000 may include a camera 2040 disposed on a rear side of the second housing part 2020 and a display 2050 disposed on a rear side of the third housing part 2030. For example, in a first state 2000a of the foldable electronic device 2000 illustrated in FIG. 20A, a front side 2011 of the first housing part 2010, a front side 2021 of the second housing part 2020, and a front side 2031 of the third housing part 2030 may face substantially the same direction (e.g., a +z direction). The first state 2000a of the foldable electronic device 2000 may be referred to as an unfolded state of the foldable electronic device 2000. In the first state 2000a, as the first housing part 2010 rotates in a first rotation direction (e.g., clockwise) with respect to the second housing part 2020, the foldable electronic device 2000 may change from the first state 2000a of FIG. 20a to a second state 2000b of FIG. 20B.

Referring to FIG. 20B, in the second state 2000b of the foldable electronic device 2000, the front side 2011 of the first housing part 2010 may face the front side 2021 of the second housing part 2020. The second state 2000b of the foldable electronic device 2000 may be referred to as a single folded state or a half folded state of the foldable electronic device 2000. In the second state 2000b, as the third housing part 2030 rotates in a second rotation direction (e.g., counterclockwise) with respect to the second housing part 2020, the foldable electronic device 2000 may change from the second state 2000b of FIG. 20C to a third state 2000c of FIG. 20C.

Referring to FIG. 20C, in the third state 2000c of the foldable electronic device 2000, the front side of the first housing part 2010 may face the front side of the second housing part 2020, and the front side 2031 of the third housing part 2030 may face a rear side 2012 of the first housing part 2010. The third state 2000c of the foldable electronic device 2000 may be referred to as a multi-folded state of the foldable electronic device 2000. In the multi-folded state of the foldable electronic device 2000, the first housing part 2010 may be positioned between the second housing part 2020 and the third housing part 2030.

Referring to FIG. 20C, in the multi-folded state of the foldable electronic device 2000, a first bracket 2013, a second bracket 2023, and a third bracket 2033 may overlap each other. A parasitic effect may be caused by a capacitance formed between brackets overlapping each other. As described above, a structure for adjusting the capacitance formed between the brackets may be substantially equally applied to the foldable electronic device 2000 illustrated in FIGS. 20A, 20B, and 20C.

Referring to FIG. 21, the above-described structure may be substantially equally applied to the first housing part 2010 of FIG. 21. For example, in the multi-folded state of the foldable electronic device 2000, a fourth bracket 701 and/or an enclosure 702 may be used to control a capacitance formed between the first bracket 2013 of the first housing part 2010 and the third bracket 2033 of the third housing part 2030. The fourth bracket 701 of the first housing part 2010 and/or the enclosure 702 may be used as the plate 610 described above.

For example, the fourth bracket 701 may be electrically connected to a ground layer of a printed circuit board (PCB) 620 via switch circuitry 650 and impedance circuitry 640. The ground layer of the PCB 620 may be electrically connected to the first bracket 2013 corresponding to a ground of the first housing part 2010. As the fourth bracket 701 is electrically connected to the ground layer of the PCB 620, the fourth bracket 701 may be electrically connected to the first bracket 2013. According to a parameter value of a lumped element of the impedance circuitry 640, the capacitance between the first bracket 2013 and the third bracket 2033 may be adjusted. According to the parameter value, a parasitic resonance caused by the capacitance may shift out of a frequency band of RF signals transmitted and/or received via an antenna of the foldable electronic device 2000.

For example, the enclosure 702 may be electrically connected to a ground layer of another different PCB 710 via another switch circuitry 730 and another impedance circuitry 740. The ground layer of the other PCB 710 may be electrically connected to the first bracket 2013 corresponding to the ground of the first housing part 2010. As the enclosure 702 is electrically connected to the ground layer of the other PCB 710, the enclosure 702 may be electrically connected to the first bracket 2013. According to a parameter value of a lumped element of the other impedance circuitry 740, the capacitance between the first bracket 2013 and the third bracket 2033 may be adjusted. According to the parameter value, the parasitic resonance caused by the capacitance may shift out of the frequency band of the RF signals transmitted and/or received via the antenna of the foldable electronic device 2000.

The technical problems to be achieved in the present disclosure are not limited to those described above, and other technical problems not mentioned herein will be clearly understood by those having ordinary knowledge in the art to which the present disclosure belongs.

A foldable electronic device 101, 200, or 2000 is described. The foldable electronic device 101, 200, or 2000 may comprise a foldable housing 201 including a first housing part 210, a second housing part 220 configured to rotate with respect to the first housing part 210, and a third housing part 230 configured to rotate with respect to the second housing part 220. A multi-folded state of the foldable electronic device 101, 200, or 2000 has a front side of the second housing part 220 facing a front side of the first housing part 210 and a front side of the third housing part 230 facing a rear side of the first housing part 210. The foldable electronic device 101, 200, or 2000 may comprise a flexible display 240 including a first portion 241 defining a portion of the front side of the first housing part 210, a second portion 242 defining a portion of the front side of the second housing part 220, and a third portion 243 defining a portion of the front side of the third housing part 230. The first housing part 210 may include a bracket 211 corresponding to a ground of the first housing part 210, a plate 610 disposed between the bracket 211 of the first housing part 210 and the rear side of the first housing part 210, a printed circuit board (PCB) 620 disposed on the bracket 211, impedance circuitry 640 disposed on the PCB 620, electrically connected to a ground layer of the PCB 620 that is electrically connected to the bracket 211, and switch circuitry 650 disposed on the PCB 620. The switch circuitry 650 may be configured to electrically connect the impedance circuitry 640 and the plate 610 based on a state of the foldable electronic device 101, 200, or 2000. For example, the switch circuitry may be configured to electrically connect or disconnect the impedance circuitry 640 and the plate 610 according to whether the state of the foldable electronic device 101, 200, or 2000 is in an unfolded state or the multi-folded state. In a case that the plate 610 is electrically connected to the impedance circuitry 640 via the switch circuitry 650, the plate 610 and the bracket 211 may be electrically connected.

According to an embodiment, the plate 610 may include a conductive portion 1110 spaced apart from the bracket 211, and a non-conductive portion 1120, coupled to a portion of a peripheral portion of the conductive portion 1110, contacted with the bracket 211, and supporting the plate 610.

According to an embodiment, the conductive portion 1110 of the plate 610 may include a first through hole 1141 disposed in the portion of the peripheral portion of the conductive portion 1110. The non-conductive portion 1120 of the plate 610 may include a second through hole 1142 aligned with the first through hole 1141 of the conductive portion 1110. The first housing part 210 may include a fastener fastening the plate 610 to the bracket 211, by being inserted into the first through hole 1141 of the conductive portion 1110 and the second through hole 1142 of the non-conductive portion 1120, and being coupled to the bracket 211.

According to an embodiment, the portion of the peripheral portion of the conductive portion 1110 may include a cut portion 1130 that is at least partially cut. The cut portion may be filled with the non-conductive portion 1120.

According to an embodiment, the plate 610 may correspond to one of a metal sheet or a plate on which a conductive paint is deposited.

According to an embodiment, the foldable electronic device 101, 200, or 2000 may further comprise a sensor 660 to identify a distance between the first housing part 210 and the second housing part 220. The switch circuitry 650 may be configured to provide an electrical connection or an electrical disconnection between the plate 610 and the impedance circuitry 640, based on the distance between the first housing part 210 and the second housing part 220 identified by the sensor 660.

According to an embodiment, the switch circuitry 650 may be configured to electrically disconnect the plate 610 and the bracket 211 by electrically disconnecting the impedance circuitry 640 from the plate 610 when the foldable electronic device 101, 200, or 2000 is in an unfolded state. The switch circuitry 650 may be configured to electrically connect the plate 610 and the bracket 211 by electrically connecting the impedance circuitry 640 to the plate 610 when the foldable electronic device 101, 200, or 2000 is in the multi-folded state.

According to an embodiment, the foldable electronic device 101, 200, or 2000 may further comprise another bracket 701 covering the PCB 620. The plate 610 may correspond to the other bracket 701.

According to an embodiment, the foldable electronic device 101, 200, or 2000 may further comprise a speaker 720 disposed in the first housing part 210 and an enclosure 702 at least partially surrounding the speaker 720. The plate 610 may correspond to the enclosure 702.

According to an embodiment, a first point P1 of the plate 610 may be electrically connected to the bracket 211 via the switch circuitry 650 and the impedance circuitry 640. A second point P2 of the plate 610 may be physically connected to the bracket 211.

According to an embodiment, a first distance D1 between the first point P1 of the plate 610 and the second point P2 of the plate 610 may be longer than a second distance D2 between the first point P1 of the plate 610 and a first lateral side 1501 of the plate 610 adjacent to the first point P1 of the plate 610, or a third distance D3 between the second point P2 of the plate 610 and a second lateral side 1502 of the plate 610 adjacent to the second point P2 of the plate 610.

According to an embodiment, the foldable electronic device 101, 200, or 2000 may further comprise a first hinge assembly 250 rotatably connecting the first housing part 210 and the second housing part 220. The foldable electronic device 101, 200, or 2000 may further comprise a second hinge assembly 260 rotatably connecting the second housing part 220 and the third housing part 230. The first hinge assembly 250 may be closer to the second point P2 of the plate 610 than the first point P1 of the plate 610.

According to an embodiment, the impedance circuitry 640 may include a capacitor 641 or an inductor 642 to control a capacitance formed in the bracket 211 by changing an impedance of the plate 610.

According to an embodiment, the switch circuitry 650 may be configured to electrically connect the plate 610 and the impedance circuitry 640 to shift a parasitic resonance of a parasitic component induced by the bracket 211, which is included in a frequency band of radio frequency (RF) signals transmitted or received, via the foldable electronic device 101, 200, or 2000, out of the frequency band.

According to an embodiment, the second housing part 220 may include another bracket 221 corresponding to a ground of the second housing part 220. The plate 610 of the first housing part 210 may be positioned between the bracket 211 of the first housing part 210 and the other bracket 221 of the second housing part 220, in the multi-folded state of the foldable electronic device 101, 200, or 2000.

According to an embodiment, the plate 610 of the first housing part 210 may be used to control a capacitance formed in the bracket 211 of the first housing part 210, in the multi-folded state of the foldable electronic device 101, 200, or 2000.

A foldable electronic device 101 or 1800 is described. The foldable electronic device 101 or 1800 may comprise a foldable housing 201 including a first housing part 1810, a second housing part 1820 configured to rotate with respect to the first housing part 1810, and a third housing part 1830 configured to rotate with respect to the second housing part 1820. A multi-folded state of the foldable electronic device 101 or 1800 may have a rear side of the first housing part 1810 facing a rear side of the second housing part 1820 and a front side of the third housing part 1830 facing a front side of the second housing part 1820. The foldable electronic device 101 or 1800 may comprise a flexible display 1840 including a first portion 1841 defining a portion of the front side of the first housing part 1810, a second portion 1842 defining a portion of the front side of the second housing part 1820, and a third portion 1843 defining a portion of the front side of the third housing part 1830. The first housing part 1810 may include a bracket 211 corresponding to a ground of the first housing part 1810, a plate 610 disposed between the bracket 211 and the rear side of the first housing part 1810, a printed circuit board (PCB) 620 disposed on the bracket 211, impedance circuitry 640 disposed on the PCB 620, electrically connected to a ground layer of the PCB 620 that is electrically connected to the bracket 211, and switch circuitry 650 disposed on the PCB 620. The switch circuitry 650 may be configured to electrically disconnect the impedance circuitry 640 from the plate 610 when the foldable electronic device 101 or 1800 is in an unfolded state. The switch circuitry 650 may be configured to electrically connect the impedance circuitry 640 to the plate 610 when the foldable electronic device 101 or 1800 is in the multi-folded state.

According to an embodiment, the plate 610 may include a conductive portion 1110 spaced apart from the bracket 211, and a non-conductive portion 1120 coupled to a portion of a peripheral portion of the conductive portion 1110, contacted with the bracket 211, and supporting the plate 610. The conductive portion 1110 of the plate 610 may include a first through hole 1141 disposed in the portion of the peripheral portion of the conductive portion 1110, and the non-conductive portion 1120 of the plate 610 may include a second through hole 1142 aligned with the first through hole 1141 of the conductive portion 1110. The first housing part 1810 may include a fastener fastening the plate 610 to the bracket 211, by being inserted into the first through hole 1141 of the conductive portion 1110 and the second through hole 1142 of the non-conductive portion 1120, and being coupled to the bracket 211.

According to an embodiment, the foldable electronic device 101 or 1800 may further comprise a sensor 660 to identify a distance between the first housing part 1810 and the second housing part 1820. The switch circuitry 650 may be configured to provide an electrical connection or an electrical disconnection between the plate 610 and the impedance circuitry 640 based on the distance between the first housing part 1810 and the second housing part 1820 identified by the sensor 660.

According to an embodiment, the foldable electronic device 101 or 1800 may further comprise another bracket 701 covering the PCB 620. The plate 610 may correspond to the other bracket 701.

According to an embodiment, the foldable electronic device 101 or 1800 may further comprise a speaker 720 disposed in the first housing part 1810 and an enclosure 702 at least partially surrounding the speaker 720. The plate 610 may correspond to the enclosure 702.

The effects that may be obtained from the present disclosure are not limited to those described above, and any other effects not mentioned herein will be clearly understood by those skilled in the art.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A foldable electronic device comprising:
a foldable housing including:
a first housing part,
a second housing part configured to rotate with respect to the first housing part, and
a third housing part configured to rotate with respect to the second housing part, wherein a multi-folded state of the foldable electronic device has a front side of the second housing part facing a front side of the first housing part and a front side of the third housing part facing a rear side of the first housing part; and
a flexible display including:
a first portion defining a portion of the front side of the first housing part,
a second portion defining a portion of the front side of the second housing part, and
a third portion defining a portion of the front side of the third housing part,
wherein the first housing part includes:
a bracket corresponding to a ground of the first housing part,
a plate, disposed between the bracket of the first housing part and the rear side of the first housing part,
a printed circuit board, PCB, disposed on the bracket,
impedance circuitry, disposed on the PCB, electrically connected to a ground layer of the PCB that is electrically connected to the bracket, and
switch circuitry, disposed on the PCB, configured to electrically connect the plate and the impedance circuitry based on a state of the foldable electronic device.

2. The foldable electronic device of claim 1,
wherein the plate includes:
a conductive portion spaced apart from the bracket, and
a non-conductive portion, coupled to a portion of a peripheral portion of the conductive portion, contacted with the bracket, and supporting the plate.

3. The foldable electronic device of claim 2,
wherein the conductive portion of the plate includes a first through hole disposed in the portion of the peripheral portion of the conductive portion,
wherein the non-conductive portion of the plate includes a second through hole aligned with the first through hole of the conductive portion, and
wherein the first housing part includes a fastener fastening the plate to the bracket, by being inserted into the first through hole of the conductive portion and the second through hole of the non-conductive portion, and being coupled to the bracket.

4. The foldable electronic device of claim 2,
wherein the portion of the peripheral portion of the conductive portion includes a cut portion that is at least partially cut, and
wherein the cut portion is filled with the non-conductive portion.

5. The foldable electronic device of any one of claims 1 to 4,
wherein the plate corresponds to one of a metal sheet or a plate on which a conductive paint is deposited.

6. The foldable electronic device of any one of claims 1 to 5,
wherein the switch circuitry is configured to:
when the foldable electronic device is in an unfolded state, electrically disconnect the plate and the bracket by electrically disconnecting the impedance circuitry from the plate, and
when the foldable electronic device is in the multi-folded state, electrically connect the plate and the bracket by electrically connecting the impedance circuitry to the plate.

7. The foldable electronic device of any one of claims 1 to 6, further comprising another bracket covering the PCB,
wherein the plate corresponds to the other bracket.

8. The foldable electronic device of any one of claims 1 to 7, further comprising:
a speaker disposed in the first housing part; and
an enclosure at least partially surrounding the speaker, and
wherein the plate corresponds to the enclosure.

9. The foldable electronic device of any one of claims 1 to 8,
wherein a first point of the plate is electrically connected to the bracket, via the switch circuitry and the impedance circuitry, and
wherein a second point of the plate is physically connected to the bracket.

10. The foldable electronic device of claim 9,
wherein a first distance between the first point of the plate and the second point of the plate is longer than a second distance between the first point of the plate and a first lateral side of the plate adjacent to the first point of the plate, or a third distance between the second point of the plate and a second lateral side of the plate adjacent to the second point of the plate.

11. The foldable electronic device of claim 9, further comprising:
a first hinge assembly rotatably connecting the first housing part and the second housing part; and
a second hinge assembly rotatably connecting the second housing part and the third housing part,
wherein the first hinge assembly is closer to the second point of the plate than the first point of the plate.

12. The foldable electronic device of any one of claims 1 to 11,
wherein the impedance circuitry includes a capacitor or an inductor to control a capacitance formed in the bracket by changing an impedance of the plate.

13. The foldable electronic device of any one of claims 1 to 12,
wherein the switch circuitry is configured to electrically connect the plate and the impedance circuitry, to shift a parasitic resonance of a parasitic component induced by the bracket, which is included in a frequency band of radio frequency, RF, signals transmitted or received, via the foldable electronic device, out of the frequency band.

14. The foldable electronic device of any one of claims 1 to 13,
wherein the second housing part includes another bracket corresponding to a ground of the second housing part, and
wherein the plate of the first housing part is positioned between the bracket of the first housing part and the other bracket of the second housing part, in the multi-folded state of the foldable electronic device.

15. The foldable electronic device of claim 14,
wherein the plate of the first housing part is used to control a capacitance formed in the bracket of the first housing part, in the multi-folded state of the foldable electronic device.
